# EUROPÄISCHE PATENTSCHRIFT

(11) **EP 2 842 004 B1**
(45) Veröffentlichungstag und Bekanntmachung des Hinweises auf die Patenterteilung: **17.04.2019**
(21) Anmeldenummer: 13786151.4
(22) Anmeldetag: 17.09.2013
(51) Int. Cl.: G05B 15/02

(54) **VERFAHREN UND ANLAGE ZUR VERFOLGUNG VON ORTSZUGEORDNETEN ENERGIEVERBRAUCHBEEINFLUSSENDEN EREIGNISSEN EINER INDUSTRIELLEN PRODUKTIONSANLAGE**
METHOD AND PLANT FOR MONITORING OF EVENTS OF AN INDUSTRIAL PRODUCTION PLANT WHICH ARE ASSOCIATED WITH A LOCATION AND INFLUENCE ENERGY CONSUMPTION
PROCÉDÉ ET INSTALLATION DE SUIVI D'ÉVÉNEMENTS INFLUANT SUR LA CONSOMMATION D'ÉNERGIE ASSOCIÉE LOCALEMENT À UNE INSTALLATION DE PRODUCTION INDUSTRIELLE

(30) Priorität: 18.09.2012 DE 102012018522
(43) Veröffentlichungstag der Anmeldung: 04.03.2015
(73) Patentinhaber: INPRO Innovationsgesellschaft für fortgeschrittene Produktionssysteme in der Fahrzeugindustrie mbH, 10587 Berlin (DE)
(72) Erfinder: THIEME, Sabine, 10823 Berlin (DE)
(74) Vertreter: Hoffmann, Klaus-Dieter
(86) Internationale Anmeldenummer: PCT/DE2013/000539
(87) Internationale Veröffentlichungsnummer: WO 2014/044246

(56) Entgegenhaltungen:
- DE-A1-102010 063 284
- DE-B3-102009 022 434
- US-A1- 2009 307 573

## Beschreibung

Die Erfindung betrifft ein Verfahren zur parallelen Verfolgung von ortszugeordneten energieverbrauchbeeinflussenden Ereignissen einer industriellen Produktionsanlage wie einer Kfz-Produktionsanlage mit einem Energieversorgungsnetz, umfassend elektrische Energie und als Energieträger dienende Medien l, mit einer Vielzahl ortsverschiedener Fertigungsbereiche i mit jeweils einer Anzahl ortsverschiedener Einzelgewerke j, denen jeweils ein zeitperiodisch vorgegebener (prozentualer) Energiebedarf und/oder ein zeitperiodisch vorgegebener (prozentualer) Bedarf der als Energieträger dienenden Medien l an Versorgungsleistung des Energieversorgungsnetz zuzuordnen ist und an denen jeweils eine kontinuierliche Messung des aktuellen (prozentualen) Verbrauchs an der Gesamtleistung des Energieversorgungsnetzes erfolgt.

Die Erfindung betrifft weiterhin eine Anlage zur parallelen (kongruenten) Verfolgung von ortzugeordneten energieverbrauchbeeinflussenden Ereignissen einer industriellen Produktionsanlage wie einer Kfz-Produktionsanlage.

In komplexen Produktionssystemen, wie z.B. in der Automobilindustrie, wird eine hohe Qualität der Produkte bei geringer Durchlaufzeit angestrebt, was eine Steigerung der Energiekosten "mit sich bringt. Es wird versucht, die Energieeffizienz sowohl durch Optimierung der Produktion, als auch durch das Minimieren energetischer Verluste in Fertigungsprozessen einer industriellen Produktionsanlage zu verbessern.

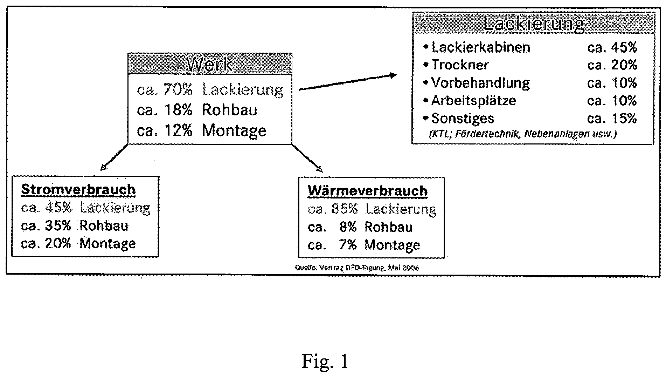

Fig. 1 der Zeichnungen zeigt eine bekannte Abbildung, die bei einem Vortrag auf der DPO-Tagung, Mai 2006 veröffentlicht worden ist und aus der ein Überblick prozentualer Energieverbräuche im Verhältnis zu dem Gesamtenergieverbrauch in der Automobilproduktion hervorgeht.

Aus der DE 10 2009 022 434 B3 geht ein Verfahren der eingangs erwähnten Art als bekannt hervor, bei dem zum automatischen Identifizieren, Überwachen und Minimieren ortszugeordneter energetischer Verluste einer industriellen Produktionsanlage, wie einer Kfz-Produktionsanlage die mindestens in jedem ortsverschiedenen Einzeigewerk der ortsverschiedenen Fertigungsbereiche der Produktionsanlage anfallenden energetischen Verluste, die sich vorrangig als thermische Verluste darstellen, mit mindestens einem Wärmebildkamerasystem signalmäßig erfasst werden. Das die energetischen Verluste des jeweiligen Einzelgewerks beinhaltende Messsignal wird gleichzeitig mit einem Ort-/Positionssignal mindestens eines Orts-/Positionssignalgebers, das dem entsprechenden Einzeigewerk jeweils zugeordnet ist, einer Auswertestation übermittelt. In der Auswertestation werden die Messsignale und zugeordneten Positionssignale sämtlicher ortsverschiedener Einzelgewerke digital verarbeitet und in einer Datenbank zeit- und ortsbezogen abgelegt. Über eine Rückkopplung werden dann von der Auswertestation Signalbefehle, deren Inhalt jeweils auf den entsprechenden datenbankmäßig erfassten energetischen Verlusten basiert, zu jeweiligen Steuerungssystemen der Einzelgewerke zum Minimieren oder Ausschalten der jeweils anfallenden energetischen Verluste übermittelt.

Aus der DE 10 2007 063 513 A1 ist weiterhin ein Verfahren zur Erfassung und Analyse von Prozessdaten hinsichtlich des Energiebedarfs und des Energieverbrauchs bei industriellen Produktionsanlagen bekannt. Hierbei wird bei einem Verbraucher, der mit Elektroenergie versorgt wird, über Stromwandler und Stromsensoren im unmittelbaren Kontakt mit der Energieversorgung der Verbraucher und berührungslos ohne Unterbrechung der Energieversorgung die zugeführte Energie datenmäßig erfasst. Die erfassten Energiedaten werden dann über eine Datenübertragungsleitung an eine Zentrale gesendet, von der nach entsprechender Datenaufbereitung und Datenauswertung Schaltcomputer Steuerbefehle zur zielgerichteten Beeinflussung des Energieverbrauchs von Produktionsprozessen erhalten. Somit kann bei einem Energieverbrauch im Bereich von Energiespitzenlasten eine Einspeisung aus anderen Energiequellen für einige oder sämtliche Verbraucher erfolgen und bei Gefahr des Überschreitens der Menge an gespeicherter Energie eine zeitliche Verschiebung des Betriebs von Verbrauchern im Produktionsablauf vorgenommen werden, um das Überschreiten zu verhindern.

Bekannt ist zudem ein Prozesssteuersystem mit Prozesssteuerinstrumenten (DE 102 95 880 B4), die jeweils ein Energiemodul enthalten, das einen für das jeweilige Prozesssteuerinstrument vorgesehenen maximalen Energiepegel steuert und von dem eine Energieeingabe bei dem jeweiligen Prozesssteuerinstrument entsprechend einem steuerbaren Grenzwert zu begrenzen ist. Zudem ist das Energiemodul mit einer Einheit ausgerüstet, mit der eine Änderungsrate der Energieeingabe bei dem Prozesssteuerinstrument gemäß einem steuerbaren Grenzwert der Änderungsraten zu begrenzen ist, so dass ein Ausbalancieren von Energielasten der Prozesssteuerinstrumente möglich ist.

Aus der EP 1 748 529 B1 ist ferner ein Verfahren zur Prognose der Energiemenge, die ein industrieller Verbraucher von einem Energieversorger benötigt, bekannt, bei dem folgende Verfahrensschritte vorgesehen sind:
In einem definierten Zeitraum wird bei mindestens einem Verbraucher eine Reihe von Ausgangsdaten aus Steuergrößen eines zukünftigen Produktionsprozesses erstellt,
mindestens ein historischer Produktionsprozess wird in Form einer Reihe von Zieldaten durch Vergleich der Reihe der erstellten Ausgangsdaten mit Datenreihen aus Steuergrößen historischer Produktionsprozesse erstellt,
zu dem ermittelten historischen Produktionsprozess wird das korrespondierende historische Energielastmuster festgestellt, und
anhand des festgestellten historischen Energielastmusters wird dann ein Prognoseplan erstellt.

Aus der DE 60 2004 012 399 T2 geht schließlich ein Verfahren zur Generierung von optimalen Steuerungsproblemen für industrielle Prozesse als bekannt hervor, bei dem eine auf Modellen basierende Steuerung oder Ablaufsteuerung des jeweiligen industriellen Prozesses entworfen wird. Die Steuerung oder Ablaufsteuerung basiert hierbei auf einem gemischt logisch-dynamischen System, das den jeweiligen industriellen Prozess repräsentiert und das aus zwei beliebig verbundenen gemischt logisch-dynamischen Teilsystemen gebildet wird.

Aus dem oben diskutierten Stand der Technik ergibt sich jedoch keinerlei Hinweis auf eine Überprüfung von aus Energiemess- sowie Vorgabewerten generierte Kennziffern für eine vorgegebene Zeitperiode auf ein außergewöhnliches Ereignis.

Der vorliegenden Erfindung liegt die Aufgabe zugrunde, ein Verfahren und eine Anlage der eingangs erwähnten Art so zu gestalten, dass für ein effizientes Energiemanagement der industriellen Produktionsanlage, wie einer Kfz-Produktionsanlage, eine stetige umfassende elektronische und/oder visuelle orts- und/oder zeitbezogene Informationsbereitstellung, die eine orts- und/oder zeitbezogene Darstellung und Bewertung außergewöhnlicher Ereignisses des Produktionsablaufs einschließt, an jedem ortverschiedenen Einzelgewerk und/oder jedem ortsverschiedenen Fertigungsbereich der industriellen Produktionsanlage verfügbar ist.

Dieser Aufgabe wird erfindungsgemäß gelöst durch ein Verfahren der eingangs erwähnten Art mit den aufeinanderfolgenden Verfahrensschritten:
- für jeden ortsverschiedenen Fertigungsbereich i oder jedes ortsverschiedene Einzeigewerk j der ortsverschiedenen Fertigungsbereiche i der Produktionsanlage werden die aktuellen Verbräuche an Energie und der als Energieträger dienenden Medien l oder nur die aktuellen Verbräuche an Energie der als Energieträger dienenden Medien erfasst, und
- für jeden ortsverschiedenen Fertigungsbereich i oder jedes ortsverschiedene Einzelgewerk j der ortsverschiedenen Fertigungsbereiche i der Produktionsanlage werden für eine vorgegebene Zeitperiode die zu erzielenden Energieverbräuche und die zu erzielenden Verbräuche der als Energieträger dienenden Medien l oder nur die zu erzielenden Verbräuche der als Energieträger dienenden Medien l vorgegeben und zeit- und ortsbezogenen Messwerten zugeordnet,
- die erfassten Messwerte der aktuellen Energieverbräuche und der aktuellen Verbräuche der als Energieträger dienenden Medien l oder nur der aktuellen Verbräuche der als Energieträger dienenden Medien l und die zugeordneten zeit- und ortsbezogenen Messwerte des für die vorgegebene Zeitperiode zu erzielenden Energiebedarfs und des zu erzielenden Bedarfs der als Energieträger dienenden Medien l oder nur des zu erzielenden Bedarfs der als Energieträger dienenden Medien l der jeweiligen ortsverschiedenen Fertigungsbereiche i oder der jeweiligen ortsverschiedenen Einzelgewerke j der ortsverschiedenen Fertigungsbereiche i der Produktionsanlage werden einer Datenbank einer Auswertestation elektronisch über eine Server-Infrastruktur zugeführt,
- in der Auswertestation wird ein Algorithmus zur Bestimmung von auf die ortsverschiedenen Fertigungsbereiche i oder auf die Einzelgewerke j der ortsverschiedenen Fertigungsbereiche i bezogenen Kennziffern k der übermittelten Messwerte der aktuellen Energieverbräuche und der aktuellen Verbräuche der als Energieträger dienenden Medien l oder nur der aktuellen Verbräuche der als Energieträger dienenden Medien l und des für die vorgegebene Zeitperiode zu erzielenden Energiebedarfs und des zu erzielenden Bedarfs der als Energieträger dienenden Medien l oder nur des vorgegebenen Bedarfs der als Energieträger dienenden Medien l festgelegt und die Kennziffern k werden visualisiert,
- in der Auswertestation werden für die ortsverschiedenen Fertigungsbereiche i oder für die Einzelgewerke j der ortsverschiedenen Fertigungsbereiche i die aktuellen Energieverbräuche und die aktuellen Verbräuche der als Energieträger dienenden Medien l oder nur die aktuellen Verbräuche der als Energieträger dienenden Medien l und die zuvor bestimmten Kennziffern des zu erzielenden Energiebedarfs und des zu erzielenden vorgegebenen Bedarfs der als Energieträger dienenden Medien l oder nur des vorgegebenen Bedarfs der als Energieträger dienenden Medien l für die vorgegebene Zeitperiode mit vorbestimmten kritischen Grenzwerten in einem elektronischen Komparator der Auswertestation verglichen und visualisiert,
- im elektronischen Komparator der Auswertestation wird für die ortsverschiedenen Fertigungsbereiche i oder für die Einzelgewerke j der ortsverschiedenen Fertigungsbereiche i zwischen aktuellen Energieverbräuchen und/oder aktuellen Verbräuchen der als Energieträger dienenden Medien l und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode der Grad der Abweichung bestimmt und bewertet sowie auftretende Über- und/oder Unterschreitungen anhand vorgegebener kritischer Grenzwerte visualisiert,
- für die ortsverschiedenen Fertigungsbereiche i oder für die Einzelgewerke j der ortsverschiedenen Fertigungsbereiche i wird eine Abweichung zwischen aktuellen Energieverbräuchen und/oder aktuellen Verbräuchen der als Energieträger dienenden Medien l und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode auf ein außergewöhnliches Ereignis im Produktionsprozess überprüft und letzteres gegebenenfalls visualisiert, und
- für die ortsverschiedenen Fertigungsbereiche i oder für die Einzelgewerke j der ortsverschiedenen Fertigungsbereiche i werden für den Fall einer Abweichung zwischen aktuellen Energieverbräuchen und/oder aktuellen Verbräuchen der als Energieträger dienenden Medien l und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode ohne ein festgestelltes außergewöhnliches Ereignis im Produktionsprozess die Abweichung visualisiert, die Ursache der Abweichung ermittelt und Maßnahmen zur Optimierung eingeleitet.

Diese Aufgabe wird erfindungsgemäß ebenso gelöst durch ein Verfahren der eingangs erwähnten Art mit den aufeinanderfolgenden Verfahrensschritten:
- für jeden ortsverschiedenen Fertigungsbereich i und jedes ortsverschiedene Einzelgewerk j der ortsverschiedenen Fertigungsbereiche i der Produktionsanlage werden die aktuellen Verbräuche an Energie und der als Energieträger dienenden Medien l oder nur die aktuellen Verbräuche an Energie der als Energieträger dienenden Medien erfasst, und
- für jeden ortsverschiedenen Fertigungsbereich i und jedes ortsverschiedene Einzelgewerk j der ortsverschiedenen Fertigungsbereiche i der Produktionsanlage werden für eine vorgegebene Zeitperiode die zu erzielenden Energieverbräuche und die zu erzielenden Verbräuche der als Energieträger dienenden Medien l oder nur die zu erzielenden Verbräuche der als Energieträger dienenden Medien l vorgegeben und zeit- und ortsbezogenen Messwerten zugeordnet,
- die erfassten Messwerte der aktuellen Energieverbräuche und der aktuellen Verbräuche der als Energieträger dienenden Medien l oder nur der aktuellen Verbräuche der als Energieträger dienenden Medien l und die zugeordneten zeit- und ortsbezogenen Messwerte des für die vorgegebene Zeitperiode zu erzielenden Energiebedarfs und des zu erzielenden Bedarfs der als Energieträger dienenden Medien l oder nur des zu erzielenden Bedarfs der als Energieträger dienenden Medien l der jeweiligen ortsverschiedenen Fertigungsbereiche i und der jeweiligen ortsverschiedenen Einzelgewerke j der ortsverschiedenen Fertigungsbereiche i der Produktionsanlage werden einer Datenbank einer Auswertestation elektronisch über eine Server-Infrastruktur zugeführt,
- in der Auswertestation wird ein Algorithmus zur Bestimmung von auf die ortsverschiedenen Fertigungsbereiche i und auf die Einzelgewerke j der ortsverschiedenen Fertigungsbereiche i bezogenen Kennziffern k der übermittelten Messwerte der aktuellen Energieverbräuche und der aktuellen Verbräuche der als Energieträger dienenden Medien l oder nur der aktuellen Verbräuche der als Energieträger dienenden Medien l und des für die vorgegebene Zeitperiode zu erzielenden Energiebedarfs und des zu erzielenden Bedarfs der als Energieträger dienenden Medien l oder nur des vorgegebenen Bedarfs der als Energieträger dienenden Medien l festgelegt und die Kennziffern k werden visualisiert,
- in der Auswertestation werden für die ortsverschiedenen Fertigungsbereiche i und für die Einzelgewerke j der ortsverschiedenen Fertigungsbereiche i die aktuellen Energieverbräuche und die aktuellen Verbräuche der als Energieträger dienenden Medien l oder nur die aktuellen Verbräuche der als Energieträger dienenden Medien l und die zuvor bestimmten Kennziffern k des zu erzielenden Energiebedarfs und des zu erzielenden Bedarfs der als Energieträger dienenden Medien l oder nur des vorgegebenen Bedarfs der als Energieträger dienenden Medien l für die vorgegebene Zeitperiode mit vorbestimmten kritischen Grenzwerten in einem elektronischen Komparator der Auswertestation verglichen und visualisiert,
- im elektronischen Komparator der Auswertestation wird für die ortsverschiedenen Fertigungsbereiche i und für die Einzelgewerke j der ortsverschiedenen Fertigungsbereiche i zwischen aktuellen Energieverbräuchen und/oder aktuellen Verbräuchen der als Energieträger dienenden Medien l und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode der Grad der Abweichung bestimmt und bewertet sowie auftretende Über- und/oder Unterschreitungen anhand vorgegebener kritischer Grenzwerte visualisiert,
- für die ortsverschiedenen Fertigungsbereiche i und für die Einzelgewerke j der ortsverschiedenen Fertigungsbereiche i wird eine Abweichung zwischen aktuellen Energieverbräuchen und/oder aktuellen Verbräuchen der als Energieträger dienenden Medien und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode auf ein außergewöhnliches Ereignis im Produktionsprozess überprüft und letzteres gegebenenfalls visualisiert, und
- für die ortsverschiedenen Fertigungsbereiche i und für die Einzelgewerke j der ortsverschiedenen Fertigungsbereiche i werden für den Fall einer Abweichung zwischen aktuellen Energieverbräuchen und/oder aktuellen Verbräuchen der als Energieträger dienenden Medien l und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode ohne ein festgestelltes außergewöhnliches Ereignis im Produktionsprozess die Abweichung visualisiert, die Ursache der Abweichung ermittelt und Maßnahmen zur Optimierung eingeleitet.

Als Energieträger dienende Medien l können Erdgas, Kohle, Koks, Öl, Wasser, Stickstoff, Druckluft und Heizwärme verwendet werden.

Bei den ortsverschiedenen Fertigungsbereichen i kann es sich um den Rohbau, die Montage, das Presswerk, die Lackierung, die Logistik, den Werkzeugbau, die Lagerhaltung und bei den ortsunterschiedlichen Einzelgewerken j um die Fertigung von Gussteilen, den Coilzuschnitt im Presswerk, die Seitenwandfertigung, die Bodengruppenfertigung, die Dachfertigung, die Tauchlackierung, den Lackauftrag, die Cockpitmontage, die Getriebefertigung, die elektrische Verkabelung und die Radmontage handeln.

Vorzugsweise handelt es sich bei den Kennziffern k um den Energiebedarf pro Produktionseinheit, den Energiebedarf pro Zeiteinheit sowie um Durchschnitts-. Minimum- und/oder Maximumwerte der an die Auswertestation (Leitstand) übermittelten Messwerte der aktuellem Energieverbräuche und/oder der Verbräuche der als Energieträger dienenden Medien l und des für die vorgegebene Zeitperiode vorgegebenen Energiebedarfs und/oder des vorgegebenen Bedarfs der als Energieträger dienenden Medien l.

Vorzugsweise werden dass Über- und/oder Unterschreitungen der vorgegebenen kritischen Grenzwerte beim Abgleich zwischen aktuellen Energieverbräuchen und/oder aktuellen Verbräuchen der als Energieträger dienenden Medien l und den Kennziffern k des vorgegebenen Energiebedarfs und/oder des vorgegebenen Bedarfs der als Energieträger dienenden Medien l für die vorgegebene Zeitperiode für die ortsverschiedenen Fertigungsbereiche i und/oder für die Einzelgewerke j der ortsverschiedenen Fertigungsbereiche i durch den Komparator als n.i.O. klassifiziert und durch einen ausgangsseitig mit dem Komparator verbundenen elektronischen Signalgeber akustisch und/oder visuell angezeigt.

Die vorgegebenen Zeitperioden können in der Vergangenheit, in der Gegenwart oder in der Zukunft liegen. Für vorgegebene zukünftige Zeitperioden können der zu erwartende Energiebedarf und/oder der zu erwartende Bedarf der als Energieträger dienenden Medien l für die ortsverschiedenen Fertigungsbereiche i und/oder für die Einzelgewerke j der ortsverschiedenen Fertigungsbereiche i vorzugsweise auch hochgerechnet oder prognostiziert werden.

Bevorzugt erfolgt die Visualisierung der aktuellen Energieverbräuche und/oder der Verbräuche der als Energieträger dienenden Medien l und des für die vorgegebene Zeitperiode vorgegebenen Energiebedarfs und/oder des vorgegebenen Bedarfs der als Energieträger dienenden Medien l für die ortsverschiedenen Fertigungsbereiche i und/oder für die Einzelgewerke j der ortsverschiedenen Fertigungsbereiche i durch Tachometer und/oder auf einem Zeitstrahl in Thermometer-Darstellung, in der vorgegebene kritische Grenzwerte und/oder Übergangsbereiche farblich markiert werden.

Bei den außergewöhnlichen Ereignissen im Produktionsprozess kann es sich um Sonderschichten, Betriebsversammlungen, Instandhaltungsmaßnahmen, Optimierungsmaßnahmen, Produktionsprogrammänderungen, Ausbaumaßnahmen, Montage- und/oder Demontagemaßnahmen oder dgl. handeln.

Die Visualisierung kann auf mit der Server-Infrastruktur über das interne Netzwerk und/oder das Internet verbundenen elektronischen Endgeräten und/oder mit mobilen elektronischen Endgeräten erfolgen, die sich innerhalb und/oder außerhalb der Produktionsanlage befinden, wobei die Server-Infrastruktur und die elektronischen Endgeräte und/oder die mobilen elektronischen Endgeräte bidirektional verbunden sind.

Die Aufgabe der vorliegenden Erfindung wird ebenso durch eine Anlage der eingangs erwähnten Art gelöst, die folgende Merkmale aufweist:
eine Server-Infrastruktur, die einen zentralen Server mit einer Datenbank aufweist, in der eine Vielzahl von Informationen zusammenzuführen und zu speichern ist, die von einer Vielzahl über ein internes, lokales oder globales Netzwerk mit dem zentralen Server verbundenen elektronischen Endgeräten oder mobilen elektronischen Endgeräten bereitzustellen sind,
wobei die aktuellen Energieverbräuche und die aktuellen Verbräuche der als Energieträger dienenden Medien l oder nur die aktuellen Verbräuche letzterer von Messsystemen der ortsverschiedenen Fertigungsbereiche i oder der Einzelgewerke j der ortsverschiedenen Fertigungsbereiche i zu erfassen und der Datenbank einzugeben und zu speichern sind,
der Datenbank des zentralen Servers ist der Produktionsplan einzugeben,
die in der Datenbank gespeicherten Messwerte der Verbräuche an Energie und/der Verbräuche der als Energieträger dienenden Medien l oder nur der Verbräuche letzterer sind über die Server-Infrastruktur über ein lokales, internes oder globales Netzwerk bidirektional abzurufen bzw. zu übermitteln und auf elektronischen Endgeräten oder mobilen elektronischen Endgeräten zu visualisieren,
im zentralen Server ist ein Algorithmus zur Bestimmung von auf die ortsverschiedenen Fertigungsbereiche i oder auf die Einzelgewerke j der ortsverschiedenen Fertigungsbereiche i bezogenen Kennziffern k der an die Datenbank übermittelten Messwerte der aktuellen Energieverbräuche und der aktuellen Verbräuche der als Energieträger dienenden Medien 1 oder nur die aktuellen Verbräuche letzterer sowie des für die vorgegebene Zeitperiode zu erzielenden Energiebedarfs und des vorgegebenen Bedarfs der als Energieträger dienenden Medien l oder nur des vorgegebenen Bedarfs letzterer festzulegen,
im zentralen Server sind für die ortsverschiedenen Fertigungsbereiche i oder für die Einzelgewerke j der ortsverschiedenen Fertigungsbereiche i die aktuellen Energieverbräuche und die aktuellen Verbräuche der als Energieträger dienenden Medien l oder nur die aktuellen Verbräuche letzterer oder die zuvor bestimmten Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode mit vorgegebenen kritischen Grenzwerten in einem elektronische Komparator zu vergleichen und zu visualisieren, und
im elektronischen Komparator des zentralen Servers sind für die ortsverschiedenen Fertigungsbereiche i oder für die Einzelgewerke j der ortsverschiedenen Fertigungsbereiche i zwischen aktuellen Energieverbräuchen und aktuellen Verbräuchen der als Energieträger dienenden Medien l oder nur aktuellen Verbräuchen letzterer sowie den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode der Grad der Abweichung zu bestimmen und zu bewerten sowie auftretende Über- oder Unterschreitungen anhand vorgegebener kritischer Grenzwerte zu visualisieren.

Die Aufgabe der vorliegenden Erfindung wird auch durch eine Anlage der eingangs erwähnten Art gelöst, die folgende Merkmale aufweist:
eine Server-Infrastruktur, die einen zentralen Server mit einer Datenbank aufweist, in der eine Vielzahl von Informationen zusammenzuführen und zu speichern ist, die von einer Vielzahl über ein internes, lokales oder globales Netzwerk mit dem zentralen Server verbundenen elektronischen Endgeräten oder mobilen elektronischen Endgeräten bereitzustellen sind,
wobei die aktuellen Energieverbräuche und die aktuellen Verbräuche der als Energieträger dienenden Medien l oder nur die aktuellen Verbräuche letzterer von Messsystemen der ortsverschiedenen Fertigungsbereiche i und der Einzelgewerke j der ortsverschiedenen Fertigungsbereiche i zu erfassen und der Datenbank einzugeben und zu speichern sind,
der Datenbank des zentralen Servers ist der Produktionsplan einzugeben,
die in der Datenbank gespeicherten Messwerte der Verbräuche an Energie und/der Verbräuche der als Energieträger dienenden Medien l oder nur der Verbräuche letzterer sind über die Server-Infrastruktur über ein lokales, internes oder globales Netzwerk bidirektional abzurufen bzw. zu übermitteln und auf elektronischen Endgeräten oder mobilen elektronischen Endgeräten zu visualisieren,
im zentralen Server ist ein Algorithmus zur Bestimmung von auf die ortsverschiedenen Fertigungsbereiche i und auf die Einzelgewerke j der ortsverschiedenen Fertigungsbereiche i bezogenen Kennziffern k der an die Datenbank übermittelten Messwerte der aktuellen Energieverbräuche und der aktuellen Verbräuche der als Energieträger dienenden Medien l oder nur die aktuellen Verbräuche letzterer sowie des für die vorgegebene Zeitperiode zu erzielenden Energiebedarfs und des vorgegebenen Bedarfs der als Energieträger dienenden Medien l oder nur des vorgegebenen Bedarfs letzterer festzulegen,
im zentralen Server sind für die ortsverschiedenen Fertigungsbereiche i und für die Einzelgewerke j der ortsverschiedenen Fertigungsbereiche i die aktuellen Energieverbräuche und die aktuellen Verbräuche der als Energieträger dienenden Medien l oder nur die aktuellen Verbräuche letzterer oder die zuvor bestimmten Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode mit vorgegebenen kritischen Grenzwerten in einem elektronische Komparator zu vergleichen und zu visualisieren, und
im elektronischen Komparator des zentralen Servers sind für die ortsverschiedenen Fertigungsbereiche i und für die Einzelgewerke j der ortsverschiedenen Fertigungsbereiche i zwischen aktuellen Energieverbräuchen und aktuellen Verbräuchen der als Energieträger dienenden Medien l oder nur aktuellen Verbräuchen letzterer sowie den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode der Grad der Abweichung zu bestimmen und zu bewerten sowie auftretende Über- oder Unterschreitungen anhand vorgegebener kritischer Grenzwerte zu visualisieren.

Vorzugsweise ist mit dem elektronischen Komparator des zentralen Servers ausgangsseitig ein elektronischer Signalgeber verbunden, von dem Über- und/oder Unterschreitungen vorbestimmter kritischer Grenzwerte, die vom Komparator als n.i.O. klassifiziert worden sind, akustisch und/oder visuell anzuzeigen sind. Die Visualisierung kann auf elektronischen Endgeräten und/oder mobilen elektronischen Endgeräten als Tachometer- oder Thermometer-Darstellung erfolgen. Auch können eine Ampel und/oder ein Blinklicht zur visuellen Anzeige und/oder ein Alarmton und/oder eine Alarmsirene zur akustischen Anzeige vorgesehen sein.

Die Erfindung erweist sich in der Lage, außergewöhnliche Produktionsereignisse im Produktionsprozess wie z. B. Sonderschichten, Betriebsversammlungen, Instandhaltungsmaßnahmen, Optimierungsmaßnahmen, Produktionsprogrammänderungen, Ausbaumaßnahmen, Montage- und/oder Demontagemaßnahmen aus Quellsystemen zu übernehmen und darzustellen.

Durch das Zusammenführen einer Vielzahl von Informationen über den Produktionsablauf ist es möglich, Verbräuche und/oder den Bedarf von Energie und/oder den Bedarf der als Energieträger dienenden Medien und deren entsprechenden Kennziffern besser zu bewerten, wodurch unnötige und aufwändige Recherchetätigkeiten vermieden werden. Weiterhin ergibt sich durch das Darstellen der Verbräuche und/oder des Bedarfs von Energie und/oder des Bedarfs der als Energieträger dienenden Medien und/oder der entsprechenden Kennziffern der Vorteil, dass die beteiligten ortsverschiedenen Fertigungsbereiche und/oder ortsverschiedenen Einzelgewerke alle die gleiche Sicht auf die Energieeffizienz und die Auswirkungen von entsprechenden Optimierungsmaßnahmen erhalten, womit eine isolierte Sicht vermieden wird.

Die Erfindung wird nun unter Bezug auf die Zeichnungen erläutert. In diesen sind
**Fig. 2** ein Blockschaltbild, aus dem das erfindungsgemäße Verfahren hervorgeht,
**Fig. 3** eine schematische Darstellung, aus der die Server-Infrastruktur der erfindungsgemäßen Anlage hervorgeht,
**Fig. 4a** ein Diagramm, in dem die Energieverbräuche in kWh über einen Zeitstrahl aufgetragen sind,
**Fig. 4b und 4c** schematische Visualisierungen der Minimum- und Maximumwerte der Energieverbräuche in kWh gemäß Fig. 4a in Tachometer-Darstellung und
**Fig. 5** ein weiteres Diagramm, in dem die Energieverbräuche in kWh über einen Zeitstrahl aufgetragen sind, wobei eine Standardreinigung und eine Betriebspause im Diagramm enthalten sind.

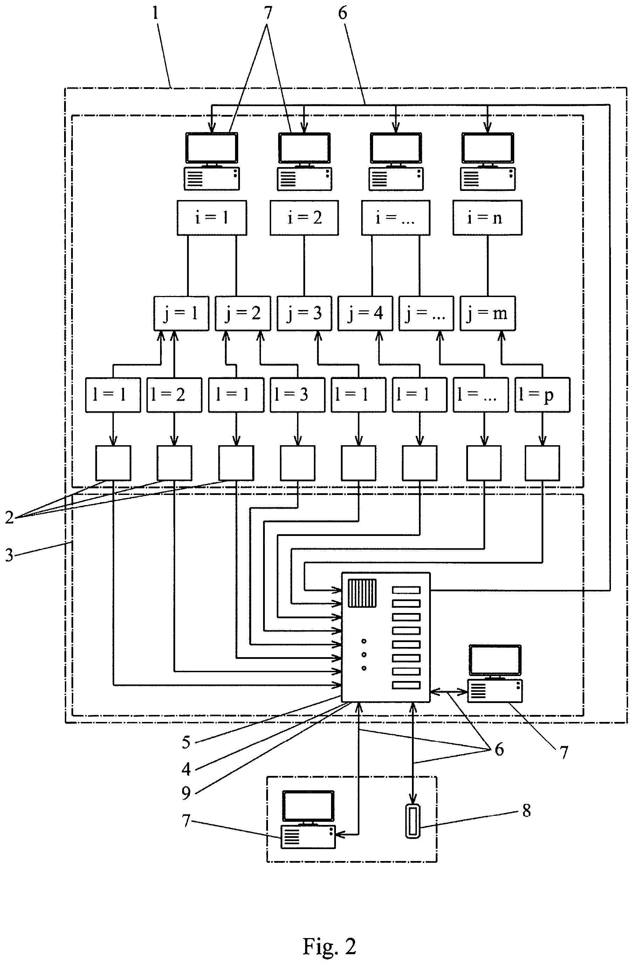

Aus Fig. 2 geht das erfindungsgemäße Verfahren hervor. In der Fertigung einer Produktionsanlage 1 werden in einer Anzahl i = 1, 2, ..., n ortsverschiedener Fertigungsbereiche mit einer Anzahl j = 1, 2, ..., m ortsverschiedener Einzelgewerke Energie und/oder als Energieträger dienende Medien l = 1, 2, ..., p verbraucht. Beispielsweise werden gemäß Fig. 2 im Fertigungsbereich i = 1 mit den Einzelgewerken j = 1 und j = 2 im Einzelgewerk j = 1 Energie und/oder als Energieträger dienenden Medien l = 1 und l = 2 verbraucht, während im Einzelgewerk j = 2 Energie und/oder als Energieträger dienende Medien l = 1 und l = 3 verbraucht werden. Im Fertigungsbereich i = 1 mit dem Einzeigewerk j = 3 wird hingegen lediglich Energie oder ein als Energieträger dienendes Medium l = 1 verbraucht.

Die aktuellen Verbräuche an Energie und/oder die Verbräuche von als Energieträger dienenden Medien l = 1, 2, ..., p werden in jedem ortsverschiedenen Fertigungsbereich i = 1, 2, ..., n und/oder jedem ortsverschiedenen Einzeigewerk j = 1, 2, ..., m mit einem Messsystem 2 erfasst. Anschließend werden die gemessenen aktuellen Verbräuche an Energie und/oder die Verbräuche der als Energieträger dienenden Medien l = 1, 2, ..., p an eine Auswertestation (Leitstand) 3 übermittelt und dort in einer Datenbank 4 gespeichert. Die in der Datenbank 4 gespeicherten Messwerte der Verbräuche an Energie und/oder der Verbräuche der als Energieträger dienenden Medien l = 1, 2, ..., p können über eine Server-Infrastruktur 5 über ein lokales, internes und/oder globales Netzwerk 6 bidirektional abgerufen bzw. übermittelt und auf elektronischen Endgeräten 7 und/oder mobilen elektronischen Endgeräten 8 visualisiert werden. Die Visualisierung der Verbräuche an Energie und/oder der Verbräuche der als Energieträger dienenden Medien l = 1, 2, ..., p erfolgt dabei vorzugsweise tabellarisch oder in graphischer Darstellung über einen Zeitstrahl.

Für die in der Datenbank 4 gespeicherten Messwerte der Verbräuche an Energie und/oder der Verbräuche als der Energieträger dienenden Medien l = 1, 2, ..., p werden gemäß einem Algorithmus verschiedene Kenziffern k = 1, 2, ..., o für eine vorgegebene Zeitperiode bestimmt, wobei die Kennziffern vorzugsweise Durchschnitts-, Minimum- und oder Maximumwerte der Verbräuche an Energie und/oder der Verbräuche der als Energieträger dienenden Medien l = 1, 2, ..., p für die vorgegebene Zeitperiode sowie der Verbräuche an Energie und/oder der Verbräuche der als Energieträger dienenden Medien l = 1, 2, ..., p pro Produktionseinheit und/oder Zeiteinheit darstellen.

Die Kennziffern k = 1, 2, ..., o werden anschließend in einem Komparator 9 mit vorbestimmten kritischen Grenzwerten verglichen, bewertet und visualisiert. Die Visualisierung erfolgt dabei vorzugsweise über eine Server-Infrastruktur 5 auf elektronischen Endgeräten 7 und/oder mobilen elektronischen Endgeräten 8 in Tachometer- oder Thermometer-Darstellung, wobei unkritische Bereiche grün, Übergangsbereiche gelb und kritische Bereiche rot dargestellt sind. Bevorzugt erfolgt die Visualisierung in jedem Fertigungsbereich i = 1, 2, ..., m und/oder jedem Einzelgewerk j = 1, 2, ..., m einzeln. Neben einer Visualisierung in der Auswertestation (Leitstand) 3 kann die Visualisierung jedoch auch außerhalb der Produktionsanlage 1, d. h. auf elektronischen Endgeräten 7 und/oder mobilen elektronischen Endgeräten 8 stattfinden, die über eine globale Netzwerkverbindung 6 mit der Server-Infrastruktur 5 verbunden sind.

Über- und/oder Unterschreitungen vorbestimmter kritischer Grenzwerte, die vom Komparator 9 als n.i.O. klassifiziert worden sind, können über einen ausgangsseitig mit dem Komparator 9 verbundenen elektronischen Signalgeber akustisch und/oder visuell angezeigt werden. Neben einer Tachometer- oder Thermometer-Darstellung auf elektronischen Endgeräten 7 und/oder mobilen elektronischen Endgeräten 8 kann bevorzugt eine Ampel oder ein Blinklicht zur visuellen Anzeige sowie ein Alarmton oder eine Alarmsirene zur akustischen Anzeige Verwendung finden. Eine elektronische Datenübermittlung in Form einer Textnachricht an elektronische Endgeräte 7 und/oder mobile elektronische Endgeräte 8 kommt ebenfalls in Betracht.

Beim Abgleich des in der 4 Datenbank gespeicherten Produktionsplans 10 mit den Kennziffern k = 1, 2, ..., o kann eine Abweichung zwischen aktuellen Energieverbräuchen und/oder aktuellen Verbräuchen der als Energieträger dienenden Medien l = 1, 2, ..., p und den Kennziffern k = 1, 2, ..., o des vorgegebenen Energiebedarfs und/oder des vorgegebenen Bedarfs der als Energieträger dienenden Medien l = 1, 2, ..., p für die vorgegebene Zeitperiode auf ein außergewöhnliches Ereignis im Produktionsprozess und ein außergewöhnliches Ereignis im Produktionsprozess wie z. B. Sonderschichten, Betriebsversammlungen, Instandhaltungsmaßnahmen, Optimierungsmaßnahmen, Produktionsprogrammänderungen, Ausbaumaßnahmen, Montage- und/oder Demontagemaßnahmen oder dgl. überprüft und gegebenenfalls visualisiert werden.

Sofern für die vorgegebene Zeitperiode kein außergewöhnliches Ereignis im Produktionsprozess festgestellt worden ist, werden die Ursache der Abweichung ermittelt und entsprechende Maßnahmen zur Fehlerbehebung eingeleitet.

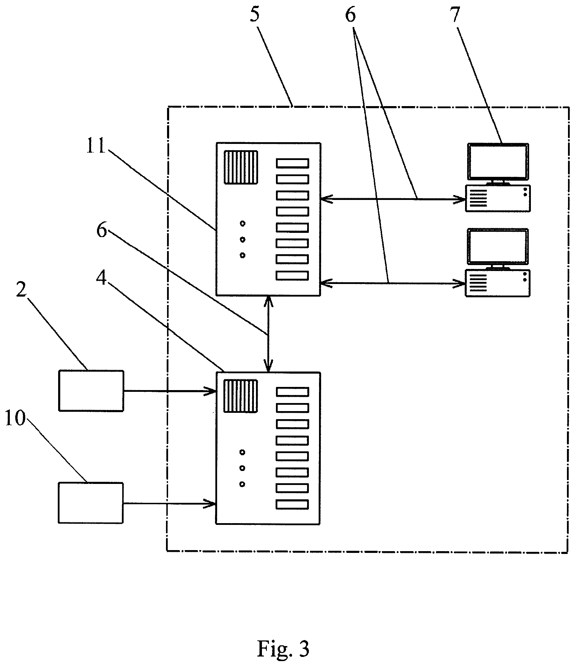

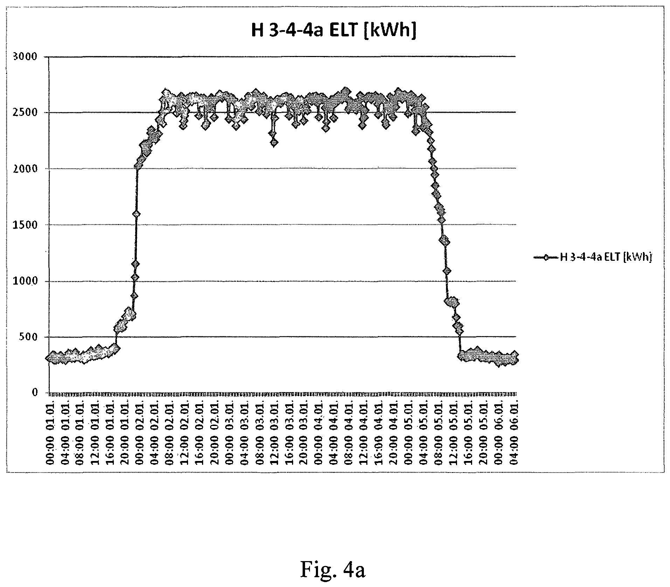

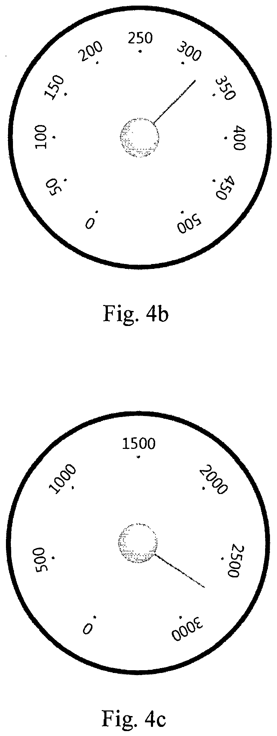

In Fig. 3 ist die Server-Infrastruktur 5 schematisch dargestellt. Messwerte der aktuellen Verbräuche an Energie und/oder der aktuellen Verbräuche der als Energieträger dienenden Medien l = 1, 2, ..., p werden nach der Erfassung durch ein Messsystem 2 an die Datenbank 4 übermittelt und gespeichert. Der Produktionsplan 10 wird ebenfalls an die Datenbank 4 übermittelt und gespeichert. Auf einem zentralen Server 11 werden die Kennziffern k = 1, 2, ..., o gemäß eines Algorithmus bestimmt. Anschließend werden die Kennziffern k = 1, 2, ..., o mit vorbestimmten kritischen Grenzwerten von dem elektronischen Komparator 9 im zentralen Server 11 verglichen und bewertet. Die kritischen Grenzwerte können hierbei zuvor von elektronischen Endgeräten 7 und/oder mobilen elektronischen Endgeräten 8 dem zentralen Server 11 vorgegeben werden. Die Visualisierung erfolgt vorzugsweise über den zentralen Server 11 auf elektronischen Endgeräten 7 und/oder mobilen elektronischen Endgeräten 8 in Tachometer- oder Thermometer-Darstellung oder als graphisches Diagramm der Verbräuche über einen Zeitstrahl. Eine derartiges graphisches Diagramm des Energieverbrauchs in kWh über einen Zeitstrahl zeigt Fig. 4a. Die Fig. 4b und 4c zeigen für die Kennziffern Minimumwert bzw. Maximumwert gemäß Fig. 4a jeweils eine Tachometer-Darstellung.

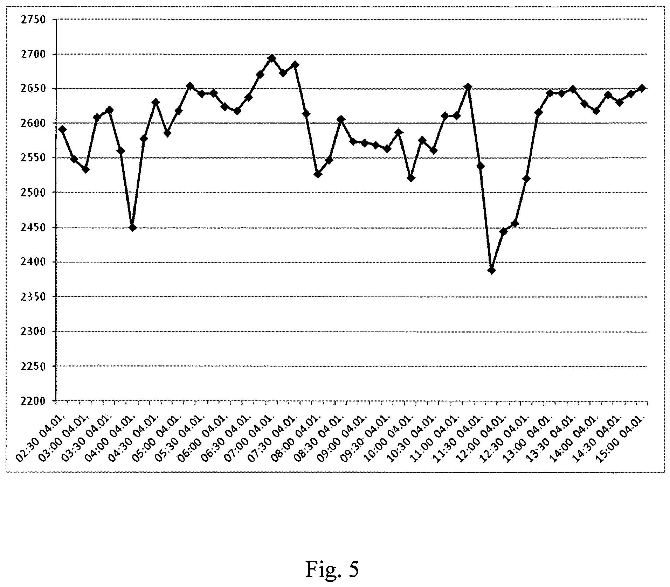

Fig. 5 zeigt ein weiteres Diagramm des Energieverbrauchs in kWh über einen Zeitstrahl für einen Fertigungsbereich und/oder ein Einzelgewerk einer Produktionsanlage 1, dem für eine Zeitperiode jeweils ein Einbruch des Energieverbrauchs während einer Standardreinigung und einer Betriebspause zu entnehmen ist.

### Bezugszeichenliste

- **1**: Produktionsanlage
- **2**: Messsysteme
- **3**: Auswertestation (Leitstand)
- **4**: Datenbank
- **5**: Server-Infrastruktur
- **6**: lokales, internes und/oder globales Netzwerk
- **7**: elektronische Endgeräte
- **8**: mobile elektronische Endgeräte
- **9**: elektronischer Komparator
- **10**: Produktionsplan
- **11**: zentraler Server
- **i**: Fertigungsbereiche
- **j**: Einzelgewerke
- **k**: Kennziffern
- **l**: als Energieträger dienende Medien

## Patentansprüche

1. Verfahren zur Verfolgung von ortszugeordneten energieverbrauch-beeinflussenden Ereignissen einer industriellen Produktionsanlage wie einer Kfz-Produktionsanlage mit einem Energieversorgungsnetz, umfassend elektrische Energie und als Energieträger dienende Medien l, mit einer Vielzahl ortsverschiedener Fertigungsbereiche i mit jeweils einer Anzahl ortsverschiedener Einzelgewerke j, denen jeweils ein zeitperiodisch vorgegebener Energiebedarf- und ein zeitperiodisch vorgegebener Bedarf der als Energieträger dienenden Medien l oder nur ein zeitperiodisch vorgegebener Bedarf letzterer an Versorgungsleistung des Energieversorgungsnetzes zuzuordnen ist und an denen jeweils eine kontinuierliche Messung des aktuellen Verbrauchs an der Gesamtleistung des Energieversorgungsnetzes erfolgt, wobei das Verfahren folgende Verfahrensschritte aufweist:
- für jeden ortsverschiedenen Fertigungsbereich i oder jedes ortsverschiedene Einzeigewerk j der ortsverschiedenen Fertigungsbereiche i der Produktionsanlage werden die aktuellen Verbräuche an Energie und der als Energieträger dienenden Medien l oder nur die aktuellen Verbräuche an Energie der als Energieträger dienenden Medien erfasst, und
- für jeden ortsverschiedenen Fertigungsbereich i oder jedes ortsverschiedene Einzelgewerk j der ortsverschiedenen Fertigungsbereiche i der Produktionsanlage werden für eine vorgegebene Zeitperiode die zu erzielenden Energieverbräuche und die zu erzielenden Verbräuche der als Energieträger dienenden Medien l oder nur die zu erzielenden Verbräuche der als Energieträger dienenden Medien l vorgegeben und zeit- und ortsbezogenen Messwerten zugeordnet,
- die erfassten Messwerte der aktuellen Energieverbräuche und der aktuellen Verbräuche der als Energieträger dienenden Medien l oder nur der aktuellen Verbräuche der als Energieträger dienenden Medien l und die zugeordneten zeit- und ortsbezogenen Messwerte des für die vorgegebene Zeitperiode zu erzielenden Energiebedarfs und des zu erzielenden Bedarfs der als Energieträger dienenden Medien l oder nur des zu erzielenden Bedarfs der als Energieträger dienenden Medien l der jeweiligen ortsverschiedenen Fertigungsbereiche i oder der jeweiligen ortsverschiedenen Einzelgewerke j der ortsverschiedenen Fertigungsbereiche i der Produktionsanlage werden einer Datenbank einer Auswertestation elektronisch über eine Server-Infrastruktur zugeführt,
- in der Auswertestation wird ein Algorithmus zur Bestimmung von auf die ortsverschiedenen Fertigungsbereiche i oder auf die Einzelgewerke j der ortsverschiedenen Fertigungsbereiche i bezogenen Kennziffern k der übermittelten Messwerte der aktuellen Energieverbräuche und der aktuellen Verbräuche der als Energieträger dienenden Medien l oder nur der aktuellen Verbräuche der als Energieträger dienenden Medien l und des für die vorgegebene Zeitperiode zu erzielenden Energiebedarfs und des zu erzielenden Bedarfs der als Energieträger dienenden Medien l oder nur des vorgegebenen Bedarfs der als Energieträger dienenden Medien l festgelegt und die Kennziffern k werden visualisiert,
- in der Auswertestation werden für die ortsverschiedenen Fertigungsbereiche i oder für die Einzelgewerke j der ortsverschiedenen Fertigungsbereiche i die aktuellen Energieverbräuche und die aktuellen Verbräuche der als Energieträger dienenden Medien 1 oder nur die aktuellen Verbräuche der als Energieträger dienenden Medien l und die zuvor bestimmten Kennziffern des zu erzielenden Energiebedarfs und des zu erzielenden Bedarfs der als Energieträger dienenden Medien l oder nur des vorgegebenen Bedarfs der als Energieträger dienenden Medien l für die vorgegebene Zeitperiode mit vorbestimmten kritischen Grenzwerten in einem elektronischen Komparator der Auswertestation verglichen und visualisiert,
- im elektronischen Komparator der Auswertestation wird für die ortsverschiedenen Fertigungsbereiche i oder für die Einzelgewerke j der ortsverschiedenen Fertigungsbereiche i zwischen aktuellen Energieverbräuchen und aktuellen Verbräuchen der als Energieträger dienenden Medien l oder nur aktuellen Verbräuchen letzterer sowie den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode der Grad der Abweichung bestimmt und bewertet sowie auftretende Über- und/oder Unterschreitungen anhand vorgegebener kritischer Grenzwerte visualisiert,
- für die ortsverschiedenen Fertigungsbereiche i oder für die Einzelgewerke j der ortsverschiedenen Fertigungsbereiche i wird eine Abweichung zwischen aktuellen Energieverbräuchen und aktuellen Verbräuchen der als Energieträger dienenden Medien l oder nur aktuellen Verbräuchen letzterer sowie den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode auf ein außergewöhnliches Ereignis im Produktionsprozess überprüft und letzteres gegebenenfalls visualisiert, und
- für die ortsverschiedenen Fertigungsbereiche i oder für die Einzelgewerke j der ortsverschiedenen Fertigungsbereiche i werden für den Fall einer Abweichung zwischen aktuellen Energieverbräuchen und/oder aktuellen Verbräuchen der als Energieträger dienenden Medien l und den Kennziffern k des z u erzielenden Energiebedarfs und des zu erzielenden Bedarfs der als Energieträger dienenden Medien l oder nur des zu erzielenden Bedarfs letzterer für die vorgegebene Zeitperiode ohne ein festgestelltes außergewöhnliches Ereignis im Produktionsprozess die Abweichung visualisiert, die Ursache der Abweichung ermittelt und Maßnahmen *zur* Optimierung eingeleitet.

2. Verfahren zur Verfolgung von ortszugeordneten energieverbrauch-beeinflussenden Ereignissen einer industriellen Produktionsanlage wie einer Kfz-Produktionsanlage mit einem Energieversorgungsnetz, umfassend elektrische Energie und als Energieträger dienende Medien l mit einer Vielzahl ortsverschiedener Fertigungsbereiche i mit jeweils einer Anzahl ortsverschiedener Einzelgewerke j, denen jeweils ein zeitperiodisch vorgegebener Energiebedarf- und ein zeitperiodisch vorgegebener Bedarf der als Energieträger dienenden Medien l oder nur ein zeitperiodisch vorgegebener Bedarf letzterer an Versorgungsleistung des Energieversorgungsnetzes zuzuordnen ist und an denen jeweils eine kontinuierliche Messung des aktuellen Verbrauchs an der Gesamtleistung des Energieversorgungsnetzes erfolgt, wobei das Verfahren folgende Verfahrensschritte aufweist:
- für jeden ortsverschiedenen Fertigungsbereich i und jedes ortsverschiedene Einzelgewerk j der ortsverschiedenen Fertigungsbereiche i der Produktionsanlage werden die aktuellen Verbräuche an Energie und der als Energieträger dienenden Medien l oder nur die aktuellen Verbräuche an Energie der als Energieträger dienenden Medien erfasst, und
- für jeden ortsverschiedenen Fertigungsbereich i und jedes ortsverschiedene Einzelgewerk j der ortsverschiedenen Fertigungsbereiche i der Produktionsanlage werden für eine vorgegebene Zeitperiode die zu erzielenden Energieverbräuche und die zu erzielenden Verbräuche der als Energieträger dienenden Medien 1 oder nur die zu erzielenden Verbräuche der als Energieträger dienenden Medien l vorgegeben und zeit- und ortsbezogenen Messwerten zugeordnet,
- die erfassten Messwerte der aktuellen Energieverbräuche und der aktuellen Verbräuche der als Energieträger dienenden Medien l oder nur der aktuellen Verbräuche der als Energieträger dienenden Medien l und die zugeordneten zeit- und ortsbezogenen Messwerte des für die vorgegebene Zeitperiode zu erzielenden Energiebedarfs und des zu erzielenden Bedarfs der als Energieträger dienenden Medien l oder nur des zu erzielenden Bedarfs letzterer der jeweiligen ortsverschiedenen Fertigungsbereiche i und der jeweiligen ortsverschiedenen Einzelgewerke j der ortsverschiedenen Fertigungsbereiche i der Produktionsanlage werden einer Datenbank einer Auswertestation elektronisch über eine Server-Infrastruktur zugeführt,
- in der Auswertestation wird ein Algorithmus zur Bestimmung von auf die ortsverschiedenen Fertigungsbereiche i und/ auf die Einzelgewerke j der ortsverschiedenen Fertigungsbereiche i bezogenen Kennziffern k der übermittelten Messwerte der aktuellen Energieverbräuche und der aktuellen Verbräuche der als Energieträger dienenden Medien l oder nur der aktuellen Verbräuche der als Energieträger dienenden Medien l und des für die vorgegebene Zeitperiode zu erzielenden Energiebedarfs und des zu erzielenden Bedarfs der als Energieträger dienenden Medien l oder nur des vorgegebenen Bedarfs der als Energieträger dienenden Medien l festgelegt und die Kennziffern k werden visualisiert,
- in der Auswertestation werden für die ortsverschiedenen Fertigungsbereiche i und für die Einzelgewerke j der ortsverschiedenen Fertigungsbereiche i die aktuellen Energieverbräuche und die aktuellen Verbräuche der als Energieträger dienenden Medien l oder nur die aktuellen Verbräuche der als Energieträger dienenden Medien l und die zuvor bestimmten Kennziffern k des zu erzielenden Energiebedarfs und des zu erzielenden Bedarfs der als Energieträger dienenden Medien l oder nur des vorgegebenen Bedarfs der als Energieträger dienenden Medien l für die vorgegebene Zeitperiode mit vorbestimmten kritischen Grenzwerten in einem elektronischen Komparator der Auswertestation verglichen und visualisiert,
- im elektronischen Komparator der Auswertestation wird für die ortsverschiedenen Fertigungsbereiche i und für die Einzelgewerke j der ortsverschiedenen Fertigungsbereiche i zwischen aktuellen Energieverbräuchen und/ oder aktuellen Verbräuchen der als Energieträger dienenden Medien l und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode der Grad der Abweichung bestimmt und bewertet sowie auftretende Über- oder Unterschreitungen anhand vorgegebener kritischer Grenzwerte visualisiert,
- für die ortsverschiedenen Fertigungsbereiche i und/oder für die Einzelgewerke j der ortsverschiedenen Fertigungsbereiche i wird eine Abweichung zwischen aktuellen Energieverbräuchen und/oder aktuellen Verbräuchen der als Energieträger dienenden Medien l und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode auf ein außergewöhnliches Ereignis im Produktionsprozess überprüft und letzteres gegebenenfalls visualisiert, und
- für die ortsverschiedenen Fertigungsbereiche i und/oder für die Einzelgewerke j der ortsverschiedenen Fertigungsbereiche i werden für den Fall einer Abweichung zwischen aktuellen Energieverbräuchen und/oder aktuellen Verbräuchen der als Energieträger dienenden Medien l und den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode ohne ein festgestelltes außergewöhnliches Ereignis im Produktionsprozess die Abweichung visualisiert, die Ursache der Abweichung ermittelt und Maßnahmen zur Optimierung eingeleitet.

3. Verfahren nach Anspruch 1 oder 2, **dadurch gekennzeichnet, dass** die vorgegebenen Zeitperioden in der Vergangenheit, in der Gegenwart oder in der Zukunft liegen.

4. Verfahren nach einem der Ansprüche 1-3, **dadurch gekennzeichnet, dass** als Energieträger dienende Medien l Erdgas, Kohle, Koks, Öl, Wasser, Stickstoff, Druckluft und Heizwärme verwendet werden.

5. Verfahren nach einem der vorhergehenden Ansprüche, **dadurch gekennzeichnet, dass** die ortsunterschiedlichen Fertigungsbereiche i der Rohbau, die Montage, das Presswerk, die Lackierung, die Logistik, den Werkzeugbau oder die Lagerhaltung sind.

6. Verfahren nach einem der vorhergehenden Ansprüche, **dadurch gekennzeichnet, dass** die ortsunterschiedlichen Einzelgewerke j die Fertigung von Gussteilen, der Coilzuschnitt im Presswerk, die Seitenwandfertigung, die Bodengruppenfertigung, die Dachfertigung, die Tauchlackierung, der Lackauftrag, die Cockpitmontage, die Getriebefertigung, die elektrische Verkabelung oder die Radmontage sind.

7. Verfahren nach einem der vorhergehenden Ansprüche, **dadurch gekennzeichnet, dass** es sich bei den Kennziffern k um den Energiebedarf pro Produktionseinheit, den Energiebedarf pro Zeiteinheit sowie um Durchschnitts-. Minimum- und/oder Maximumwerte der an die Auswertestation übermittelten Messwerte der aktuellem Energieverbräuche und der aktuellen Verbräuche der als Energieträger dienenden Medien l oder nur der aktuellen Verbräuche letzterer sowie des für die vorgebene Zeitperiode zu erzielenden Energiebedarfs und des zu erzielenden Bedarfs der als Energieträger dienenden Medien l oder nur des zu erzielenden Bedarfs letzterer handelt.

8. Verfahren nach einem der vorhergehenden Ansprüche, **dadurch gekennzeichnet, dass** Über- oder Unterschreitungen der vorgegebenen kritischen Grenzwerte beim Abgleich zwischen aktuellen Energieverbräuchen und aktuellen Verbräuchen der als Energieträger dienenden Medien l oder nur von aktuellen Verbräuchen letzterer sowie den Kennziffern k des vorgegebenen Energiebedarfs und des vorgegebenen Bedarfs der als Energieträger dienenden Medien l oder nur des vorgegebenen Bedarfs letzterer für die vorgegebene Zeitperiode für die ortsverschiedenen Fertigungsbereiche i und für die Einzelgewerke j der ortsverschiedenen Fertigungsbereiche i oder nur für die Einzelgewerke letzterer durch den Komparator nicht in Ordnung klassifiziert und durch einen ausgangsseitig mit dem Komparator verbundenen elektronischen Signalgeber akustisch oder visuell angezeigt werden.

9. Verfahren nach einem der vorhergehenden Ansprüche, **dadurch gekennzeichnet, dass** die Visualisierung der aktuellen Energieverbräuche und der Verbräuche der als Energieträger dienenden Medien l oder nur der Verbräuche letzterer sowie des für die vorgegebene Zeitperiode zu erzielenden Energiebedarfs und des zu erzielenden Bedarfs der als Energieträger dienenden Medien l oder nur des zu erzielenden Bedarfs letzterer für die ortsverschiedenen Fertigungsbereiche i und für die Einzelgewerke j der ortsverschiedenen Fertigungsbereiche i oder nur für die Einzelgewerke letzterer durch Ampel-, Tachometer- oder Thermometer-Darstellung erfolgt, in der vorgegebene kritische Grenzwerte und Übergangsbereiche farblich markiert werden.

10. Verfahren nach einem der vorhergehenden Ansprüche, **dadurch gekennzeichnet, dass** es sich bei den außergewöhnlichen Ereignissen im Produktionsprozess um Sonderschichten, Betriebsversammlungen, Instandhaltungsmaßnahmen, Optimierungsmaßnahmen, Produktionsprogrammänderungen, Ausbaumaßnahmen, Montage- oder Demontagemaßnahmen handelt.

11. Verfahren nach einem der vorhergehenden Ansprüche, **dadurch gekennzeichnet, dass** die Visualisierung auf mit der Server-Infrastruktur über das interne Netzwerk oder das Internet verbundenen elektronischen Endgeräten oder mit mobilen elektronischen Endgeräten erfolgt, die sich innerhalb oder außerhalb der Produktionsanlage befinden, wobei die Server-Infrastruktur und die elektronischen Endgeräte und die mobilen elektronischen Endgeräte bidirektional verbunden sind.

12. Anlage zur Verfolgung von ortszugeordneten energieverbrauch-beeinflussenden Ereignissen einer industriellen Produktionsanlage (1) wie einer Kfz-Produktionsanlage mit einem Energieversorgungsnetz, umfassend elektrische Energie und als Energieträger dienende Medien l mit einer Vielzahl ortsverschiedener Fertigungsbereiche i mit jeweils einer Anzahl ortsverschiedener Einzelgewerke j, denen jeweils ein zeitperiodisch vorgegebener Energiebedarf- und/ ein zeitperiodisch vorgegebener Bedarf der als Energieträger dienenden Medien l oder nur ein zeitperiodisch vorgegebener Bedarf letzterer an Versorgungsleistung des Energieversorgungsnetzes zuzuordnen ist und an denen jeweils eine kontinuierliche Messung des aktuellen Verbrauchs an der Gesamtleistung des Energieversorgungsnetzes durchzuführen ist, mit folgenden Merkmalen:
eine Server-Infrastruktur (5), die einen zentralen Server (11) mit einer Datenbank (4) aufweist, in der eine Vielzahl von Informationen zusammenzuführen und zu speichern ist, die von einer Vielzahl über ein internes, lokales oder globales Netzwerk (6) mit dem zentralen Server (11) verbundenen elektronischen Endgeräten (7) oder mobilen elektronischen Endgeräten (8) bereitzustellen sind,
wobei die aktuellen Energieverbräuche und die aktuellen Verbräuche der als Energieträger dienenden Medien l oder nur die aktuellen Verbräuche letzterer von Messsystemen (2) der ortsverschiedenen Fertigungsbereiche i oder der Einzelgewerke j der ortsverschiedenen Fertigungsbereiche i zu erfassen und der Datenbank (4) einzugeben und zu speichern sind, der Datenbank (4) des zentralen Servers (11) ist der Produktionsplan (10) einzugeben,
die in der Datenbank (4) gespeicherten Messwerte der Verbräuche an Energie und/der Verbräuche der als Energieträger dienenden Medien l oder nur der Verbräuche letzterer sind über die Server-Infrastruktur (5) über ein lokales, internes oder globales Netzwerk (6) bidirektional abzurufen bzw. zu übermitteln und auf elektronischen Endgeräten (7) oder mobilen elektronischen Endgeräten (8) zu visualisieren,
im zentralen Server (11) ist ein Algorithmus zur Bestimmung von auf die ortsverschiedenen Fertigungsbereiche i oder auf die Einzelgewerke j der ortsverschiedenen Fertigungsbereiche i bezogenen Kennziffern k der an die Datenbank (4) übermittelten Messwerte der aktuellen Energieverbräuche und der aktuellen Verbräuche der als Energieträger dienenden Medien l oder nur die aktuellen Verbräuche letzterer sowie des für die vorgegebene Zeitperiode zu erzielenden Energiebedarfs und des *zu* erzielenden Bedarfs der als Energieträger dienenden Medien l oder nur des zu erzielenden Bedarfs letzterer festzulegen,
im zentralen Server (11) sind für die ortsverschiedenen Fertigungsbereiche i oder für die Einzelgewerke j der ortsverschiedenen Fertigungsbereiche i die aktuellen Energieverbräuche und die aktuellen Verbräuche der als Energieträger dienenden Medien l oder nur die aktuellen Verbräuche letzterer oder die zuvor bestimmten Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode mit vorgegebenen kritischen Grenzwerten in einem elektronische Komparator (9) zu vergleichen und zu visualisieren, und
im elektronischen Komparator (9) des zentralen Servers (11) sind für die ortsverschiedenen Fertigungsbereiche i oder für die Einzelgewerke j der ortsverschiedenen Fertigungsbereiche i zwischen aktuellen Energieverbräuchen und aktuellen Verbräuchen der als Energieträger dienenden Medien l oder nur aktuellen Verbräuchen letzterer sowie den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode der Grad der Abweichung zu bestimmen und zu bewerten sowie auftretende Über- oder Unterschreitungen anhand vorgegebener kritischer Grenzwerte zu visualisieren.

13. Anlage zur Verfolgung von ortszugeordneten energieverbrauch-beeinflussenden Ereignissen einer industriellen Produktionsanlage (1) wie einer Kfz-Produktionsanlage mit einem Energieversorgungsnetz, umfassend elektrische Energie und als Energieträger dienende Medien l mit einer Vielzahl ortsverschiedener Fertigungsbereiche i mit jeweils einer Anzahl ortsverschiedener Einzelgewerke j, denen jeweils ein zeitperiodisch vorgegebener Energiebedarf- und/ ein zeitperiodisch vorgegebener Bedarf der als Energieträger dienenden Medien l oder nur ein zeitperiodisch vorgegebener Bedarf letzterer an Versorgungsleistung des Energieversorgungsnetzes zuzuordnen ist und an denen jeweils eine kontinuierliche Messung des aktuellen Verbrauchs an der Gesamtleistung des Energieversorgungsnetzes durchzuführen ist, mit folgenden Merkmalen:
eine Server-Infrastruktur (5), die einen zentralen Server (11) mit einer Datenbank (4) aufweist, in der eine Vielzahl von Informationen zusammenzuführen und zu speichern ist, die von einer Vielzahl über ein internes, lokales oder globales Netzwerk (6) mit dem zentralen Server (11) verbundenen elektronischen Endgeräten (7) oder mobilen elektronischen Endgeräten (8) bereitzustellen sind,
wobei die aktuellen Energieverbräuche und die aktuellen Verbräuche der als Energieträger dienenden Medien l oder nur die aktuellen Verbräuche letzterer von Messsystemen (2) der ortsverschiedenen Fertigungsbereiche i und der Einzelgewerke j der ortsverschiedenen Fertigungsbereiche i zu erfassen und der Datenbank (4) einzugeben und zu speichern sind,
der Datenbank (4) des zentralen Servers (11) ist der Produktionsplan (10) einzugeben,
die in der Datenbank (4) gespeicherten Messwerte der Verbräuche an Energie und/der Verbräuche der als Energieträger dienenden Medien l oder nur der Verbräuche letzterer sind über die Server-Infrastruktur (5) über ein lokales, internes oder globales Netzwerk (6) bidirektional abzurufen bzw. zu übermitteln und auf elektronischen Endgeräten (7) oder mobilen elektronischen Endgeräten (8) zu visualisieren,
im zentralen Server (11) ist ein Algorithmus zur Bestimmung von auf die ortsverschiedenen Fertigungsbereiche i und auf die Einzelgewerke j der ortsverschiedenen Fertigungsbereiche i bezogenen Kennziffern k der an die Datenbank (4) übermittelten Messwerte der aktuellen Energieverbräuche und der aktuellen Verbräuche der als Energieträger dienenden Medien l oder nur die aktuellen Verbräuche letzterer sowie des für die vorgegebene Zeitperiode zu erzielenden Energiebedarfs und des *zu* erzielenden Bedarfs der als Energieträger dienenden Medien l oder nur des zu erzielenden Bedarfs letzterer festzulegen,
im zentralen Server (11) sind für die ortsverschiedenen Fertigungsbereiche i und für die Einzelgewerke j der ortsverschiedenen Fertigungsbereiche i die aktuellen Energieverbräuche und die aktuellen Verbräuche der als Energieträger dienenden Medien l oder nur die aktuellen Verbräuche letzterer oder die zuvor bestimmten Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode mit vorgegebenen kritischen Grenzwerten in einem elektronische Komparator (9) zu vergleichen und zu visualisieren, und
im elektronischen Komparator (9) des zentralen Servers (11) sind für die ortsverschiedenen Fertigungsbereiche i und für die Einzelgewerke j der ortsverschiedenen Fertigungsbereiche i zwischen aktuellen Energieverbräuchen und aktuellen Verbräuchen der als Energieträger dienenden Medien l oder nur aktuellen Verbräuchen letzterer sowie den Kennziffern k des zu erzielenden Energiebedarfs und des zu erzielenden Bedarfs der als Energieträger dienenden Medien l oder nur des zu erzielenden Bedarfs letzterer für die vorgegebene Zeitperiode der Grad der Abweichung zu bestimmen und zu bewerten sowie auftretende Über- oder Unterschreitungen anhand vorgegebener kritischer Grenzwerte zu visualisieren.

14. Anlage nach Anspruch 12 oder 13, **dadurch gekennzeichnet, dass** mit dem elektronischen Komparator (9) des zentralen Servers (11) ausgangsseitig ein elektronischer Signalgeber verbunden ist, von dem Über- oder Unterschreitungen vorbestimmter kritischer Grenzwerte, die vom elektronischen Komparator (9) als nicht in Ordnung klassifiziert worden sind, akustisch oder visuell anzuzeigen sind.

15. Anlage nach Anspruch 12 oder 13, **dadurch gekennzeichnet, dass** die Visualisierung auf elektronischen Endgeräten (7) oder mobilen elektronischen Endgeräten (8) als Tachometer- oder Thermometer-Darstellung gegeben ist.

16. Anlage nach Anspruch 12 oder 13, **dadurch gekennzeichnet, dass** eine Ampel oder ein Blinklicht zur visuellen Anzeige und ein Alarmton oder eine Alarmsirene zur akustischen Anzeige vorgesehen sind.

## Claims

1. Method for tracking of location-associated power-influencing events of an industrial production plant such as a motor vehicle production line with a power supply network, comprising electrical power and media l serving as energy carrier, with a plurality of variously locatedproduction areas i, each having a number of variously located individual specialist groups j, to each of which a periodically predetermined energy requirement and a periodically predetermined requirement of the media l serving as energy carrier or a periodically predetermined requirement of the latter onlyin terms of power supply from the power supply network is to be assigned,and at each of which a continuous measurement of the current consumption of the total output of the power supply network is carried out, wherein the method includes the following method steps:
- the current consumptionsof energy and of the media l serving as energy carrier or only the current energy consumptions of the media serving as energy carrier are captured for each variously located production area i or each variously located individual specialist group j of the variously located production areas i of the production plant, and
- the target consumptions of energy and the target consumptions of the media l serving as energy carrier or only the target consumptions of the media l serving as energy carrier for a predetermined time period are prescribed and assigned to measured values with regard to time and location for each variously located production area i or each variously located individual specialist group j of the variously located production areas i of the production plant,
- the captured measurement values for the current energy consumptions and for the current consumptions of the media l serving as energy carrier or only the current consumptions of the media l serving as energy carrier and the assigned time- and location-related measurement values of the target energy requirement and of the target requirement of the media l serving as energy carrier or only of the target requirement of the media l serving as energy carrier for the predetermined time period of the respective variously located production areas i or the respective variously located individual specialist groups j of the variously located production areas i of the production plant are fed electronically to a database of an the evaluation station via a server infrastructure,
- in the evaluation station, an algorithm for determiningkey indicators k of the transmitted measured values of the current energy consumptions and of the current consumptions of the media l serving as energy carrier, or only of the current consumptions of the media l serving as energy carrier and of the target energy requirement and of the target requirement of media l serving as energy carrier or only of the target requirement for the media l serving as energy carrier for the predetermined time periodrelating to the variously located production areas i or the individual specialist groups j of the variously located production areas i is defined and the key indicators k are displayed,
- in the evaluation station, the current energy consumptions and the current consumptions of the media l serving as energy carrier, or only the current consumptions of the media l serving as energy carrier and the previously determined key indicators k for the target energy requirement and the target requirement for media l serving as energy carrier or only the target requirement for media l serving as energy carrier for the predetermined time period are compared with critical limit values in an electronic comparator of the evaluation station and displayed for the variously located production areas i or for the individual specialist groups j of the variously located production areas i,
- in the electronic comparator of the evaluation station, the degree of deviation between current energy consumptions and current consumptions of the media l serving as carrier or only the current consumptions of the latter and the target energy requirement and the target requirement of the media l serving as carrier or only the target requirement of the latter for the predetermined time period is determined and evaluated for the variously located production areas i or for the individual specialist groups j of the variously located production areas i, and values which exceed and/or fall below the prescribed critical limit values are displayed,
- a deviation between current energy consumptions and current consumptions of the media l serving as energy carrier or only the current consumptions of the latter and the key indicators k of the target energy requirement and the target requirement of the media l serving as energy carrier or only the target requirement of the latter for the predetermined time period for the variously located production areas i or for the individual specialist groups j of the variously located production areas i is checked for an unusual event in the production process, and any such event is displayed as necessary, and
- if a deviation is detected between current energy consumptions and/or current consumptions of the media l serving as energy carrier and the key indicators k of the target energy requirement and the target requirement of the media l serving as energy carrier or only the target requirement of the latter for the predetermined time period for the variously located production areas i or for the individual specialist groups j of the variously located production areas i, without display of a detected exceptional event in the production process, the deviation is displayed, the cause of the deviation is determined, and measures *for* optimisation are initiated.

2. Method for tracking of location-associated power-influencing events of an industrial production plant such as a motor vehicle production line with a power supply network, comprising electrical power and media l serving as energy carrier, with a plurality of variously located production areas i, each having a number of variously located individual specialist groups j, to each of which a periodically predetermined energy requirement and a periodically predetermined requirement of the media l serving as energy carrier or a periodically predetermined requirement of the latter only in terms of power supply from the power supply network is to be assigned, and at each of which a continuous measurement of the current consumption of the total output of the power supply network is carried out, wherein the method includes the following method steps:
- the current consumptions of energy and of the media l serving as energy carrier or only the current energy consumptions of the media serving as energy carrier are captured for each variously located production area i or each variously located individual specialist group j of the variously located production areas i of the production plant, and
- the target consumptions of energy and the target consumptions of the media l serving as energy carrier or only the target consumptions of the media l serving as energy carrier for a predetermined time period are prescribed and assigned to measured values with regard to time and location for each variously located production area i or each variously located individual specialist group j of the variously located production areas i of the production plant,
- the captured measurement values for the current energy consumptions and for the current consumptions of the media l serving as energy carrier or only the current consumptions of the media l serving as energy carrier and the assigned time- and location-related measurement values of the target energy requirement and of the target requirement of the media l serving as energy carrier or only of the target requirement of the latter for the predetermined time period of the respective variously located production areas i and the respective variously located individual specialist groups j of the variously located production areas i of the production plant are fed electronically to a database of an the evaluation station via a server infrastructure,
- in the evaluation station, the current energy consumptions and the current consumptions of the media l serving as energy carrier, or only the current consumptions of the media l serving as energy carrier and the previously determined key indicators k for the target energy requirement and the target requirement for media l serving as energy carrier or only the target requirement for media l serving as energy carrier for the predetermined time period are compared with critical limit values in an electronic comparator of the evaluation station and displayed for the variously located production areas i and for the individual specialist groups j of the variously located production areas i,
- in the electronic comparator of the evaluation station, the degree of deviation between current energy consumptions and/or current consumptions of the media l serving as carrier and the key indicator k for the target energy requirement and the target requirement of the media l serving as carrier or only the target requirement of the latter for the predetermined time period is determined and evaluated for the variously located production areas i or for the individual specialist groups j of the variously located production areas i, and values which exceed and/or fall below the prescribed critical limit values are displayed,
- a deviation between current energy consumptions and/or current consumptions of the media l serving as energy carrier and the key indicators k of the target energy requirement and the target requirement of the media l serving as energy carrier or only the target requirement of the media l serving as energy carrier for the predetermined time period for the variously located production areas iand/or for the individual specialist groups j of the variously located production areas i is checked for an unusual event in the production process, and any such event is displayed as necessary, and
- if a deviation is detected between current energy consumptions and/or current consumptions of the media l serving as energy carrier and the key indicators k of the target energy requirement and the target requirement of the media l serving as energy carrier or only the target requirement of the latter for the predetermined time period for the variously located production areas iand/or for the individual specialist groups j of the variously located production areas i, without display of a detected exceptional event in the production process, the deviation is displayed, the cause of the deviation is determined, and measures *for* optimisation are initiated.

3. Method according to Claim 1 or 2, **characterized in that** the predetermined time periods are in the past, in the presence or in the future.

4. Method according to any one of Claims 1 to 3, **characterized** in thatnatural gas, coal, coke, oil, water, nitrogen, compressed air and heating energy can be used for the media 1 serving as energy carrier.

5. Method according to any one of the preceding claims, **characterized in that** the variously located production areas i are shell construction, assembly, the pressing plant, painting, logistics, toolmaking or warehousing.

6. Method according to any one of the preceding claims, **characterized in that** the variously located individual specialist groups j are cast parts production, coil customisation in the pressing plant, sidewall production, floor assembly production, roof production, dip coating,coating application, cockpit assembly, transmission production, electrical wiring or wheel assembly.

7. Method according to any one of the preceding claims, **characterized in that** the key indicators k are the energy required per production unit, the energy requirement per unit of time as well as average,minimum and/or maximum values of the measured values transmitted to the evaluation station of the current energy consumptions and the current consumptions of the media l serving as energy carrier or only the current consumptions of the latter for the predetermined period and of the target energy requirement and the target requirement of media l serving as energy carrier or only of the target requirement of the latter for the predetermined period.

8. Method according to any one of the preceding claims, **characterized in that** cases in which values exceed or fall below the prescribed critical limit values during a comparison between current energy consumptions and current consumptions of the media l serving as energy carrier or of the current consumptions of the latter only and the key indicators k of the prescribed energy requirement and the prescribed requirement of the media l serving as energy carrier or the prescribed requirement of the latter for the predetermined time period for the variously located production areas i and for the individual specialist groups j of the variously located production areas i or only for the specialist groups thereof are classified as not OK by the comparator and reported audibly or visibly by an electronic signal generator which is connected to the output side of the comparator.

9. Method according to any one of the preceding claims, **characterized in that** the current energy consumptions and the consumptions of the media l serving as energy carrier or the consumptions of the latter only and the target energy requirement and the target requirement for the media l serving as energy carrier or the target requirement of the latter only for the variously located production areas i and for the individual specialist groups j of the variously located production areas i or only for the specialist groups thereof are displayed in the form of a traffic light, speedometer or thermometer representation, in which prescribed critical limit values and transition ranges are highlighted in colour.

10. Method according to any one of the preceding claims, **characterized in that** the exceptional events in the production process are special shifts, works meetings, maintenance activities, optimisation activities, productionprogramme changes, expansion work, installation and/or dismantling operations.

11. Method according to any one of the preceding claims, **characterized in that** the display appears on electronic end devices that are connected to the server infrastructure via the internal network or the internet or on is assured with mobile electronic devices located within or outside the production plant, wherein the server infrastructure and the electronic end devices and the mobile electronic end devices are connected bidirectionally.

12. Apparatus for tracking of location-associated power-influencing events of an industrial production plant (1) such as a motor vehicle production line with a power supply network, comprising electrical power and media l serving as energy carrier, with a multiplicity of variously located production areas i, each having a number of variously located individual specialist groups j, to each of which a periodically predetermined energy requirement and a periodically predetermined requirement of the media l serving as energy carrier or a periodically predetermined requirement of the latter only in terms of power supply from the power supply network is to be assigned, and at each of which a continuous measurement of the current consumption of the total output of the power supply network is to be carried out, having the following features:
a server infrastructure (5) including a central server (11) with a database (4), in which a large volume of information is to be compiled and stored, which information is to be provided by a multiplicity of electronic end devices (7) or mobile electronic end devices (8) which are connected to the central server (11) via an internal, local or global network (6),
wherein the current consumptions of energy and the current consumptions of the media l serving as energy carrier or only the current energy consumptions of the latter are to be captured by measuring systems (2) of the variously located production areas i or the individual specialist groups j of the variously located production areas i of the production plant and entered into the database (4) and stored there,
the production plan (10) is to be entered in the database (4) of the central server (11),
the measured values for the consumptions of energy and/or the consumptions of media l serving as energy carrier or only the consumptions of the latter are to be retrieved and/or transmitted bidirectionally from the server infrastructure (5) via a local, internal or global network (6) and displayed on electronic end devices (7) or mobile electronic end devices (8),
an algorithm is to be defined in the central server (11) for determining key indicators k relating to the variously located production areas i or the individual specialist groups j of the variously located production areas i of the measured values transmitted to the database (4) of the current energy consumptions and of the current consumptions of the media l serving as energy carrier, or only of the current consumptions of the latter and of the target energy requirement and of the target requirement of media l serving as energy carrier or of the target requirement for the latter only,
the current energy consumptions and the current consumptions of the media l serving as energy carrier or the current consumptions of the latter only or the previously determined key indicators k for the target energy requirement and the target requirement for media l serving as energy carrier or only the target requirement for the latter for the predetermined time period for the variously located production areas i or for the individual specialist groups j of the variously located production areas i are to be compared with prescribed critical limit values in an electronic comparator (9)and made available for display in the central server (11), and
the degree of deviation between current energy consumptions and current consumptions of the media l serving as carrier or only the current consumptions of the latter and the key indicators k of the target energy requirement and the target requirement of the media l serving as carrier or only the target requirement of the latter for the predetermined time period is to be determined and evaluated for the variously located production areas i or for the individual specialist groups j of the variously located production areas i in the electronic comparator (9) of the evaluation station (11), and values which exceed and/or fall below the prescribed critical limit values are to be displayed.

13. Apparatus for tracking of location-associated power-influencing events of an industrial production plant (1) such as a motor vehicle production line with a power supply network, comprising electrical power and media l serving as energy carrier, with a multiplicity of variously located production areas i, each having a number of variously located individual specialist groups j, to each of which a periodically predetermined energy requirement and a periodically predetermined requirement of the media l serving as energy carrier or a periodically predetermined requirement of the latter only in terms of power supply from the power supply network is to be assigned, and at each of which a continuous measurement of the current consumption of the total output of the power supply network is to be carried out, having the following features:
a server infrastructure (5) including a central server (11) with a database (4), in which a large volume of information is to be compiled and stored, which information is to be provided by a multiplicity of electronic end devices (7) or mobile electronic end devices (8) which are connected to the central server (11) via an internal, local or global network (6),
wherein the current consumptions of energy and the current consumptions of the media l serving as energy carrier or only the current energy consumptions of the latter are to be captured by measuring systems (2) of the variously located production areas i or the individual specialist groups j of the variously located production areas i of the production plant and entered into the database (4) and stored there,
the production plan (10) is to be entered in the database (4) of the central server (11),
the measured values for the consumptions of energy and/or the consumptions of media l serving as energy carrier or only the consumptions of the latter are to be retrieved and/or transmitted bidirectionally from the server infrastructure (5) via a local, internal or global network (6) and displayed on electronic end devices (7) or mobile electronic end devices (8),
the current energy consumptions and the current consumptions of the media l serving as energy carrier or the current consumptions of the latter only or the previously determined key indicators k for the target energy requirement and the target requirement for media l serving as energy carrier or only the target requirement for the latter for the predetermined time period for the variously located production areas i or for the individual specialist groups j of the variously located production areas i are to be compared with prescribed critical limit values in an electronic comparator (9) and made available for display in the central server (11), and
the degree of deviation between current energy consumptions and current consumptions of the media l serving as carrier or only the current consumptions of the latter and the key indicators k of the target energy requirement and the target requirement of the media l serving as carrier or only the target requirement of the latter for the predetermined time period is to be determined and evaluated for the variously located production areas i or for the individual specialist groups j of the variously located production areas i in the electronic comparator (9) of the evaluation station (11), and values which exceed and/or fall below the prescribed critical limit values are to be displayed.

14. Apparatus according to either of Claims 12 or 13, **characterized in that** a signal generator is connected to the output side of the electronic comparator (9) of the central server (11), by which generator cases in which values exceed or fall below prescribed critical limit values which are classified as not OK by the electronic comparator (9) are to be reported with a audible or visible signal.

15. Apparatus according to either of Claims 12 or 13, **characterized in that** the display appears on electronic end devices (7) or mobile electronic end devices (8) in the form of a speedometer or thermometer representation.

16. Apparatus according to either of Claims 12 or 13, **characterized in that** a traffic light or flashing display are provided for visual report and an alarm sound or alarm siren are provided for audible reporting.

## Revendications

1. Procédé, destiné à suivre des événements localisés, influençant la consommation énergétique d'une ligne de production industrielle, tellequ'une ligne de construction automobile, comportant un réseau d'alimentation en énergie, comprenant de l'énergie électrique et des agents 1 faisant office de vecteurs énergétiques, comportant une pluralité de zones de fabrication i de localisation différente, avec chacune un nombre d'équipements individuels j de localisation différente, à chacun desquels il faut associer un besoin énergétique prédéfini par périodes de tempset un besoin prédéfini par période de temps des agents 1 faisant office de vecteurs énergétiques, ou seulement un besoin prédéfini par périodes de temps de ces derniers en puissance d'alimentation par le réseau d'alimentation énergétique et sur chacun desquels a lieu respectivement une mesure continue de la consommation actuelle de la puissance globale du réseau d'alimentation en énergie, le procédé comportant les étapes de procédé suivantes, consistant à :
- pour chaquezone de fabrication i de localisation différente ou pour chaqueéquipement individuel j de localisation différente deszones de fabrication de localisation différente i de la ligne de production, on détecte lesconsommations énergétiques actuelleset celles des agents 1 faisant office de vecteurs énergétiques ou seulement les consommations énergétiques actuelles des agents 1 faisant office de vecteurs énergétiques et
- pour chaquezone de fabrication i de localisation différenteou pour chaqueéquipement individuel j de localisation différente deszones de fabrication i de localisation différente de la ligne de production, on prédéfinit pour unepériode temporelle prédéfinieles consommations énergétiques à atteindreet les consommations à atteindre desagents l faisant office de vecteurs énergétiquesou seulement les consommations à atteindre des agents 1 faisant office de vecteurs énergétiqueset on les associe à des valeurs de mesures rapportées au temps et à la localisation,
- on amène vers une base de données d'un poste d'évaluation par voie électronique via une infrastructure de serveur les valeurs mesurées détectées pour les consommations énergétiques actuelleset pour les consommations actuelles des agents 1 faisant office de vecteurs énergétiquesou uniquement pour les consommations actuelles desagents 1 faisant office de vecteurs énergétiqueset lesvaleurs de mesures rapportées au temps et à la localisation associées du besoin énergétique à atteindre pour lapériode temporelle prédéfinieet du besoin desagents 1 faisant office de vecteurs énergétiques ou uniquement du besoin à atteindre pour les agents 1 faisant office de vecteurs énergétiquesdes zones de fabrication i de localisation différente en question ou deséquipements individuels j de localisation différente en questiondeszones de fabrication i de localisation différente de la ligne de production,
- dans leposte d'évaluation, on définit un algorithmepour déterminer le besoin énergétique à atteindre pour des indicateurs k rapportés aux zones de fabrication i de localisation différenteou auxéquipements individuels j des zones de fabrication i de localisation différentedes valeurs mesurées transmises pour les consommations énergétiques actuelles et pour lesconsommations actuelles des agents l faisant office de vecteurs énergétiquesou uniquement pour les consommations actuelles desagents 1 faisant office de vecteurs énergétiques etpour le besoin énergétique à atteindre pour lapériode temporelle prédéfinieet pour le besoin à atteindre des agents 1 faisant office de vecteurs énergétiquesou uniquement pour le besoin prédéfini desagents 1 faisant office de vecteurs énergétiques et on visualise les indicateurs k,
- dans leposte d'évaluation, on compare pour leszones de fabrication i de localisation différente ou pour leséquipements individuels j deszones de fabrication i de localisation différente les consommations énergétiques actuelleset lesconsommations actuelles desagents 1 faisant office de vecteurs énergétiques ou uniquement les consommations actuelles desagents 1 faisant office de vecteurs énergétiques et les indicateurs définis précédemmentpour le besoin énergétique à atteindre et pour le besoin à atteindre desagents 1 faisant office de vecteurs énergétiques ou uniquement pour le besoin prédéfini des agents 1 faisant office de vecteurs énergétiquespour lapériode temporelle prédéfinieavec des valeurs limites m critiques prédéfinies dans un comparateur électronique duposte d'évaluationet on les visualise,
- dans le comparateur électronique duposte d'évaluation, on détermine et on évalue le niveau de différence pour leszones de fabrication ide localisation différente ou pour leséquipements individuels j deszones de fabrication i de localisation différente entre desconsommations énergétiques actuelleset desconsommations actuellesdes agents 1 faisant office de vecteurs énergétiquesou uniquement desconsommations actuelles de ces derniers, ainsi que des indicateurs k du besoin énergétique à atteindre et du besoin à atteindre pour lesagents 1 faisant office de vecteurs énergétiques ou uniquement du besoin à atteindre pour ces derniers pour lapériode temporelle prédéfinie et on visualise des dépassements et/ou des non-atteintes à l'aide de valeurs limites critiques prédéfinies,
- pour les zones de fabrication i de localisation différente ou pour leséquipements individuels j deszones de fabrication i de localisation différente, on vérifie un écart entre desconsommations énergétiques actuelleset des consommations actuellesdesagents 1 faisant office de vecteurs énergétiquesou uniquement desconsommations actuelles de ces derniers, ainsi que les indicateurs k du besoin énergétique à atteindre et du besoin à atteindre pour lesagents 1 faisant office de vecteurs énergétiquesou uniquement du besoin à atteindre pour ces dernierspour lapériode temporelle prédéfinieau niveau d'un événement exceptionnel dans le processus de production et on visualise ce dernier le cas échéant et
- dans le cas d'un écart entre des consommations énergétiques actuelles et/ou des consommations actuelles des agents 1 faisant office de vecteurs énergétiques et les indicateurs k du besoin énergétique à atteindre et du besoin à atteindre pour les agents 1 faisant office de vecteurs énergétiques ou uniquement du besoin à atteindre pour ces derniers pour la période temporelle prédéfinie, en l'absence d'un événement exceptionnel constaté, pour leszones de fabrication i de localisation différente ou pour leséquipements individuels j deszones de fabricationI de localisation différente,on visualise l'écart dans le processus de production, on détermine l'origine de l'écart et on introduit des actions d'optimisation.

2. Procédé, destiné à suivre des événements localisés, influençant la consommation énergétique d'une ligne de production industrielle, telle qu'une ligne de construction automobile, comportant un réseau d'alimentation en énergie, comprenant de l'énergie électrique et des agents 1 faisant office de vecteurs énergétiques, comportant une pluralité de zones de fabrication i de localisation différente, avec chacune un nombre d'équipements individuels j de localisation différente, à chacun desquels il faut associer un besoin énergétique prédéfini par périodes de temps et un besoin prédéfini par périodes de temps des agents 1 faisant office de vecteurs énergétiques, ou seulement un besoin prédéfini par période de temps de ces derniers en puissance d'alimentation par le réseau d'alimentation énergétique et sur lesquels a lieu respectivement une mesure continue de la consommation actuelle de la puissance globale du réseau d'alimentation en énergie, le procédé comportant les étapes de procédé suivants, consistant à :
- pour chaquezone de fabrication i de localisation différente etchaqueéquipement individuel j de localisation différente deszones de fabrication i de localisation différente de la ligne de production, on détecte lesbesoins énergétiques actuelsetceux desagents 1 faisant office de vecteurs énergétiquesou uniquement lesbesoins énergétiques actuelsdes agents faisant office de vecteurs énergétiques, et
- pour chaquezone de fabrication i de localisation différente etchaqueéquipement individuel j de localisation différente deszones de fabrication i de localisation différente de la ligne de production, on prédéfinit pour unepériode temporelle prédéfinieles consommations énergétiques à atteindre et les consommations à atteindre pour lesagents 1 faisant office de vecteurs énergétiquesou uniquement lesconsommations à atteindre pour les agents 1 faisant office de vecteurs énergétiques et on les associe à des valeurs de mesures rapportées au temps et à la localisation,
- on amène vers une base de données d'un poste d'évaluation par voie électronique via une infrastructure de serveur les valeurs mesurées détectées pour les consommations énergétiques actuelles et pour les consommations actuelles des agents 1 faisant office de vecteurs énergétiques ou uniquement pour les consommations actuelles des agents 1 faisant office de vecteurs énergétiques et les valeurs de mesures rapportées au temps et à la localisation associées du besoin énergétique à atteindre pour la période temporelle prédéfinie et du besoin à atteindrepour les agents 1 faisant office de vecteurs énergétiques ou uniquement du besoin à atteindre de ces derniers des zones de fabrication i de localisation différente en question et des équipements individuels j de localisation différente en question des zones de fabrication i de localisation différente i de la ligne de production,
- dans le poste d'évaluation, on définit un algorithme pour déterminer le besoin énergétique à atteindre pour les indicateurs k rapportés aux zones de fabrication i de localisation différente et aux équipements individuels j des zones de fabrication i de localisation différente des valeurs mesurées transmises pour les consommations énergétiques actuelles et pour les consommations actuelles des agents 1 faisant office de vecteurs énergétiques ou uniquement pour les consommations actuelles des agents 1 faisant office de vecteurs énergétiques etpour le besoin énergétique à atteindre pour la période temporelle prédéfinie et pour le besoin à atteindre pour les agents 1 faisant office de vecteurs énergétiques ou uniquement pour le besoin prédéfini des agents 1 faisant office de vecteurs énergétiques et on visualise les indicateurs k,
- dans le poste d'évaluation, on compare pour les zones de fabrication i de localisation différente et pour les équipements individuels j des zones de fabrication i de localisation différente les consommations énergétiques actuelles et les consommations actuelles des agents 1 faisant office de vecteurs énergétiques ou uniquement les consommations actuelles des agents 1 faisant office de vecteurs énergétiques et les indicateurs k définis précédemment pour le besoin énergétique à atteindre et pour le besoin à atteindre pour les agents 1 faisant office de vecteurs énergétiques ou uniquement pour le besoin prédéfini des agents 1 faisant office de vecteurs énergétiques pour la période temporelle prédéfinie avec des valeurs limites m critiques prédéfinies dans un comparateur électronique duposte d'évaluation et on les visualise,
- dans le comparateur électronique du poste d'évaluation, on détermine et on évalue le niveau de différence pour les zones de fabrication i de localisation différente et pour les équipements individuels j des zones de fabrication i de localisation différente entre des consommations énergétiques actuelles et/ou des consommations actuelles des agents 1 faisant office de vecteurs énergétiques et les indicateurs k du besoin énergétique à atteindre et du besoin à atteindre pour les agents 1 faisant office de vecteurs énergétiques ou uniquement du besoin à atteindre pour ces derniers pour la période temporelle prédéfinie et on visualise des dépassements et/ou des non-atteintes à l'aide de valeurs limites critiques prédéfinies,
- pour les zones de fabrication i de localisation différente et pour les équipements individuels j des zones de fabrication i de localisation différente, on vérifie un écart entre des consommations énergétiques actuelles et/ou des consommations actuelles des agents 1 faisant office de vecteurs énergétiques et les indicateurs k du besoin énergétique à atteindre et le besoin à atteindre pour les agents 1 faisant office de vecteurs énergétiques ou uniquement du besoin à atteindre pour ces derniers pour la période temporelle prédéfinie au niveau d'un événement exceptionnel dans le processus de production et on visualise ce dernier le cas échéant et
- en l'absence de la constatation d'un événement exceptionnel, dans le cas d'un écart entre des consommations énergétiques actuelles et/ou des consommations actuelles des agents 1 faisant office de vecteurs énergétiques et les indicateurs k du besoin énergétique à atteindre et du besoin à atteindre pour les agents 1 faisant office de vecteurs énergétiques ou uniquement du besoin à atteindre pour ces derniers, pour la période temporelle prédéfinie on visualise l'écart dans le processus de production, pour leszones de fabrication i de localisation différente et/oupour leséquipements individuels j deszones de fabrication i de localisation différente,on détermine l'origine de l'écart et on engage des mesures d'optimisation.

3. Procédé selon la revendication 1 ou 2, **caractérisé** en ce quelespériodes temporelles prédéfinies se situent dans le passé, dans le présent ou dans l'avenir.

4. Procédé selon l'une quelconque des revendications 1 à 3, **caractérisé en ce qu'**on utilise en tant qu'agents 1 faisant office de vecteurs énergétiquesdu gaz naturel, du charbon, du coke, de l'huile, de l'eau, de l'azote, de l'air comprimé et de la chaleur thermique.

5. Procédé selon l'une quelconque des revendications précédentes, **caractérisé** en ce queleszones de fabrication i de localisation différente sont la fabrication de la coque, le montage, l'atelier de presse, la peinture, la logistique, la mécanique généraleou l'entreposage.

6. Procédé selon l'une quelconque des revendications précédentes, **caractérisé** en ce queles équipements individuels j de localisation différente sont la fabrication de pièces en fonte, la découpe de bobines dans l'atelier de presse, la fabrication de parois latérales, la fabrication de blocs planchers, la fabrication de toits, la peinture par immersion, l'application de peinture, le montage de postes de pilotage, le montage de boîtes de vitesses, le câblage électrique ou le montage de roues.

7. Procédé selon l'une quelconque des revendications précédentes, **caractérisé** en ce quel'indicateur k est lebesoin énergétiquepar unité de production, le besoin énergétiquepar unité de temps, ainsi que des valeurs moyennes, minimales et/oumaximales des valeurs de mesure transmises auposte d'évaluationdes consommations énergétiques actuelleset desconsommations actuelles desagents 1 faisant office de vecteurs énergétiquesouuniquement desconsommations actuellesde ces derniers, ainsi que le besoin énergétique à atteindre pour la période temporelle prédéfinieet le besoin à atteindrepour lesagents 1 faisant office de vecteurs énergétiquesouuniquement le besoin à atteindre pour ces derniers.

8. Procédé selon l'une quelconque des revendications précédentes, **caractérisé** en ce quelors du rapprochemententre desconsommations énergétiques actuelleset desconsommations actuellesdes agents 1 faisant office de vecteurs énergétiquesouuniquement desconsommations actuelles de ces derniers, ainsi que desindicateursk du besoin énergétique prédéfinietdu besoin énergétique desagents 1 faisant office de vecteurs énergétiquesouuniquement du besoin de ces derniers pour lapériode temporelle prédéfiniepour leszones de fabrication i de localisation différente et pour leséquipements individuels j deszones de fabrication i de localisation différente ouuniquement pour leséquipements individuelsde ces dernières par lecomparateur,des dépassements ou des non-atteintes des valeurs limites critiques prédéfinies sont classifiés non conformes et sont signalés acoustiquement ou visuellement par un générateur de signaux électronique, connecté sur le côté sortie avec le comparateur.

9. Procédé selon l'une quelconque des revendications précédentes, **caractérisé** en ce quela visualisation des consommations énergétiques actuelles et des consommationsdesagents 1 faisant office de vecteurs énergétiquesouuniquement des consommations de ces derniers, ainsi que du besoin énergétique à atteindre pour la période temporelle prédéfinie et du besoin à atteindre pour lesagents 1 faisant office de vecteurs énergétiquesouuniquement du besoin à atteindre pour ces derniers pour leszones de fabrication ide localisation différente etpour leséquipements individuels j deszones de fabrication ide localisation différente ou uniquement pour leséquipements individuelsde ces dernières s'effectue par une représentation de feux de signalisation, d'untachymètre ou d'un thermomètre dans laquelle des valeurs limites critiques prédéfiniesetdes plages transitoires sont marquées en couleurs.

10. Procédé selon l'une quelconque des revendications précédentes, **caractérisé en ce que** les événements extraordinaires dans le processus de production sont des équipes spéciales, des réunions d'entreprise, des travaux d'entretien, des travaux d'optimisation, des changements de programmes de production, des travaux d'agrandissement, des travaux demontage oude démontage.

11. Procédé selon l'une quelconque des revendications précédentes, **caractérisé** en ce quela visualisation s'effectue sur des terminaux électroniques connectés sur l'infrastructure de serveur via le réseau interne ou via Internet ouà l'aide determinaux électroniquesmobiles, qui se trouvent à l'intérieur ou à l'extérieur de la ligne de production, l'infrastructure de serveuretlesterminaux électroniquesetlesterminaux électroniquesmobiles étant connectés de manière bidirectionnelle.

12. Installation, destinée à suivre des événements localisés, influençant la consommation énergétique d'une ligne de production industrielle (1), telle qu'une ligne de construction automobile, comportant un réseau d'alimentation en énergie, comprenant de l'énergie électrique et des agents 1 faisant office de vecteurs énergétiques, comportant une pluralité de zones de fabrication i de localisation différente, avec chacune un nombre d'équipements individuels j de localisation différente, à chacun desquels il faut associer un besoin énergétique prédéfini par périodes de temps et un besoin prédéfini par périodes de temps des agents 1 faisant office de vecteurs énergétiques, ou seulement un besoin prédéfini par périodes de temps de ces derniers en puissance d'alimentation par le réseau d'alimentation énergétique et sur chacun desquelsdoit être réalisée une mesure continue de la consommation actuelle de la puissance globale du réseau d'alimentation en énergie, présentant les caractéristiques suivantes :
uneinfrastructure de serveur (5), qui comporte unserveur centralisé (11) pourvu d'unebase de données (4) dans laquelle doivent être regroupées et mémorisées une pluralité d'informations qui doivent être mises à disposition par une pluralité de terminaux électroniques (7) oudeterminaux électroniques (8) mobiles connectésavec le serveur centralisé (11) via un réseau (6) interne, local ou global,
les consommations énergétiques actuelles etlesconsommations actuellesdes agents 1 faisant office de vecteurs énergétiques ou uniquement lesconsommations actuellesde ces derniers devant être détectées par des systèmes de mesure (2) deszones de fabrication i de localisation différente ou deséquipements individuels j deszones de fabricationI de localisation différenteetsaisies et mémorisées dans la base de données (4),
le programme de production (10) doit être saisi dans labase de données (4) duserveur centralisé (11),
les valeurs mesurées mémorisées dans labase de données (4) des consommations énergétiqueset des consommations des agents 1 faisant office de vecteurs énergétiques ouuniquement des consommations de ces derniersdoivent être interrogées ou transmises de manière bidirectionnelle par l'intermédiaire de l'infrastructure de serveur (5) via un réseau (6) local, interne ou global et visualisées sur des terminaux électroniques (7) oudesterminaux électroniques (8) mobiles,
dans le serveur centralisé (11), il faut définir un algorithme destiné à déterminer le besoin énergétique à atteindre pour les indicateurs k rapportés auxzones de fabrication i de localisation différenteouauxéquipements individuels j deszones de fabrication i de localisation différente des valeurs mesurées transmises à labase de données (4) des consommations énergétiques actuelleset desconsommations actuellesdes agents 1 faisant office de vecteurs énergétiques ou uniquement desconsommations actuellesde ces derniers, ainsi que de besoin énergétique à atteindre pour lapériode temporelle prédéfinieet du besoin à atteindre pour les agents 1 faisant office de vecteurs énergétiquesouuniquement des besoins à atteindre pour ces derniers,
dans leserveur centralisé (11), pour les zones de fabrication i de localisation différente ou pour les équipements individuels j des zones de fabrication i de localisation différente, les consommations énergétiques actuelles et les consommations actuelles des agents 1 faisant office de vecteurs énergétiquesou uniquement lesconsommations actuelles de ces derniers oulesindicateurs k précédemment déterminés du besoin énergétique à atteindreetdu besoin à atteindre pour les agents 1 faisant office de vecteurs énergétiques ou uniquement du besoin à atteindre pour ces dernierspour lapériode temporelle prédéfinie doivent être comparées dans un comparateur électronique (9) avec desvaleurs limites critiques prédéfinieset visualisées, et
dans lecomparateur électronique(9) duserveur centralisé (11), pour les zones de fabrication i de localisation différente ou pour les équipements individuels j des zones de fabrication i de localisation différente,le niveau d'écart entre des consommations énergétiques actuelles et des consommations actuelles des agents 1 faisant office de vecteurs énergétiques ou uniquement des consommations actuelles de ces derniers ainsi que lesindicateurs k du besoin énergétique à atteindreetdu besoin à atteindre pour lesagents 1 faisant office de vecteurs énergétiquesouuniquement du besoin à atteindre pour ces dernierspour lapériode temporelle prédéfiniedoit être déterminé et évalué, et des dépassements ou non-atteintes produits doivent être visualisés à l'aide de valeurs limites critiques prédéfinies.

13. Installation, destinée à suivre des événements localisés, influençant la consommation énergétique d'une ligne de production industrielle (1), telle qu'une ligne de construction automobile, comportant un réseau d'alimentation en énergie, comprenant de l'énergie électrique et des agents 1 faisant office de vecteurs énergétiques, comportant une pluralité de zones de fabrication i de localisation différente, avec chacune un nombre d'équipements individuels j de localisation différente, à chacun desquels il faut associer un besoin énergétique prédéfini par périodes de temps et un besoin prédéfini par périodes de temps des agents 1 faisant office de vecteurs énergétiques, ou seulement un besoin prédéfini par périodes de temps de ces derniers en puissance d'alimentation par le réseau d'alimentation énergétique et sur chacun desquels doit être réalisée une mesure continue de la consommation actuelle de la puissance globale du réseau d'alimentation en énergie, présentant les caractéristiques suivantes :
une infrastructure de serveur (5), qui comporte un serveur centralisé (11) pourvu d'une base de données (4) dans laquelle doivent être regroupées et mémorisées une pluralité d'informations qui doivent être mises à disposition par une pluralité de terminaux électroniques (7) ou de terminaux électroniques (8) mobiles connectés avec le serveur centralisé (11) via un réseau (6) interne, local ou global,
les consommations énergétiques actuelles et les consommations actuelles des agents 1 faisant office de vecteurs énergétiques ou uniquement les consommations actuelles de ces derniers devant être détectées par des systèmes de mesure (2) des zones de fabrication i de localisation différente ou des équipements individuels j des zones de fabrication I de localisation différente et saisies et mémorisées dans la base de données (4),
le programme de production (10) doit être saisi dans la base de données (4) du serveur centralisé (11),
les valeurs mesurées mémorisées dans la base de données (4) des consommations énergétiques et des consommations des agents 1 faisant office de vecteurs énergétiques ou uniquement des consommations de ces derniers doivent être interrogées ou transmises de manière bidirectionnelle par l'intermédiaire de l'infrastructure de serveur (5) via un réseau (6) local, interne ou global et visualisées sur des terminaux électroniques (7) ou des terminaux électroniques (8) mobiles,
dans le serveur centralisé (11), il faut définir un algorithme destiné à déterminer le besoin énergétique à atteindre pour les indicateurs k rapportés aux zones de fabrication i de localisation différente ou aux équipements individuels j des zones de fabrication i de localisation différente des valeurs mesurées transmises à la base de données (4) des consommations énergétiques actuelles et des consommations actuelles des agents 1 faisant office de vecteurs énergétiques ou uniquement des consommations actuelles de ces derniers, ainsi que du besoin énergétique à atteindre pour la période temporelle prédéfinie et du besoin à atteindre des agents 1 faisant office de vecteurs énergétiques ou uniquement des besoins à atteindre pour ces derniers,
dans le serveur centralisé (11), pour les zones de fabrication i de localisation différente ou pour les équipements individuels j des zones de fabrication i de localisation différente 1, les consommations énergétiques actuelles et les consommations actuelles des agents 1 faisant office de vecteurs énergétiques ou uniquement les consommations actuelles de ces derniers ou les indicateurs k précédemment déterminés du besoin énergétique et du besoin à atteindre pour les agents 1 faisant office de vecteurs énergétiques ou uniquement du besoin à atteindre pour ces dernier pour la période temporelle prédéfinie doivent être comparées dans un comparateur électronique (9) avec des valeurs limites critiques prédéfinies et visualisées, et
dans le comparateur électronique (9) du serveur centralisé (11), pour les zones de fabrication i de localisation différente ou pour les équipements individuels j des zones de fabrication i de localisation différente, le niveau d'écart entre des consommations énergétiques actuelles et des consommations actuelles des agents 1 faisant office de vecteurs énergétiques ou uniquement des consommations actuelles de ces derniers ainsi que les indicateurs k du besoin énergétique à atteindre et du besoin à atteindre pour les agents 1 faisant office de vecteurs énergétiques ou uniquement du besoin à atteindre pour ces derniers pour la période temporelle prédéfinie doit être déterminé et évalué, et des dépassements ou non-atteintes produits doivent être visualisés à l'aide de valeurs limites critiques prédéfinies.

14. Installation selon la revendication 12 ou 13, **caractérisée en ce qu'**un transmetteur de signaux électronique, par lequel des dépassements et des non-atteintes de valeurs limites critiques prédéfinies qui ont été classées comme non conformes par lecomparateur électronique(9) doivent être signalées par voie acoustique ou visuelle est connecté sur le côté extérieur ducomparateur électronique(9) duserveur centralisé (11).

15. Installation selon la revendication 12 ou 13, **caractérisée en ce que** la visualisation sur desterminaux électroniques (7) oudesterminaux électroniques(8) mobiles est données comme représentation de tachymètreou de thermomètre.

16. Installation selon revendication 12 ou 13, **caractérisée** en ce quedes feux de signalisation ou un clignotant sont prévus pour la signalisation visuelle et une tonalité d'avertissement ou une sirène d'alarme sont prévues pour la signalisation acoustique.
